# EUROPEAN PATENT SPECIFICATION

(11) **EP 1 229 569 B1**
(45) Date of publication and mention of the grant of the patent: **14.12.2011**
(21) Application number: 01308520.4
(22) Date of filing: 05.10.2001
(51) Int. Cl.: H01L 21/02

(54) **Capacitor, semiconductor device comprising the same and method of fabricating thereof**
Kondensator-Halbleiteranordnung und Herstellungsmethode
Dispositif semiconducteur, condensateur et méthode de sa fabrication

(30) Priority: 31.01.2001 JP 2001022905
(43) Date of publication of application: 07.08.2002
(73) Proprietor: FUJITSU LIMITED, Kawasaki-shi, Kanagawa 211-8588 (JP)
(72) Inventor: Kurasawa, Masaki, c/o Fujitsu Limited, Kawasaki-shi, Kanakawa 211-8588 (JP); Kurihara, Kazuaki, c/o Fujitsu Limited, Kawasaki-shi, Kanakawa 211-8588 (JP); Maruyama, Kenji, c/o Fujitsu Limited, Kawasaki-shi, Kanakawa 211-8588 (JP)
(74) Representative: Fenlon, Christine Lesley

(56) References cited:
- EP-A2- 1 160 870
- US-A- 5 248 564
- US-A- 5 567 979
- US-A- 5 719 417
- US-A- 6 096 434

## Description

The present invention relates to a capacitor and a semiconductor device and methods for fabricating the same, more specifically a ferroelectric capacitor having a ferroelectric film in which an electric field application direction and a polarization axis are parallel with each other.

Ferroelectric materials, such as SrTiO₃, Pb(Zr,Ti)O₃, etc., have applications in various fields where use can be made of their high dielectric constants and polarization inversion characteristics. An example of an application utilizing their high dielectric constants is a DRAM-type semiconductor memory device which contains a capacitor using a ferroelectric film as the dielectric film, (ferroelectric capacitors), for storing information as electrical charges. An example of an application utilizing their polarization inversion characteristics is a nonvolatile memory device which contains a ferroelectric capacitor, for storing information corresponding to polarization directions of the ferroelectric film. Ferroelectric capacitors can have capacitor areas decreased by increasing capacitance values per unit area, nonvolatile devices and in general are very useful in semiconductor memory devices which are increasingly micronized.

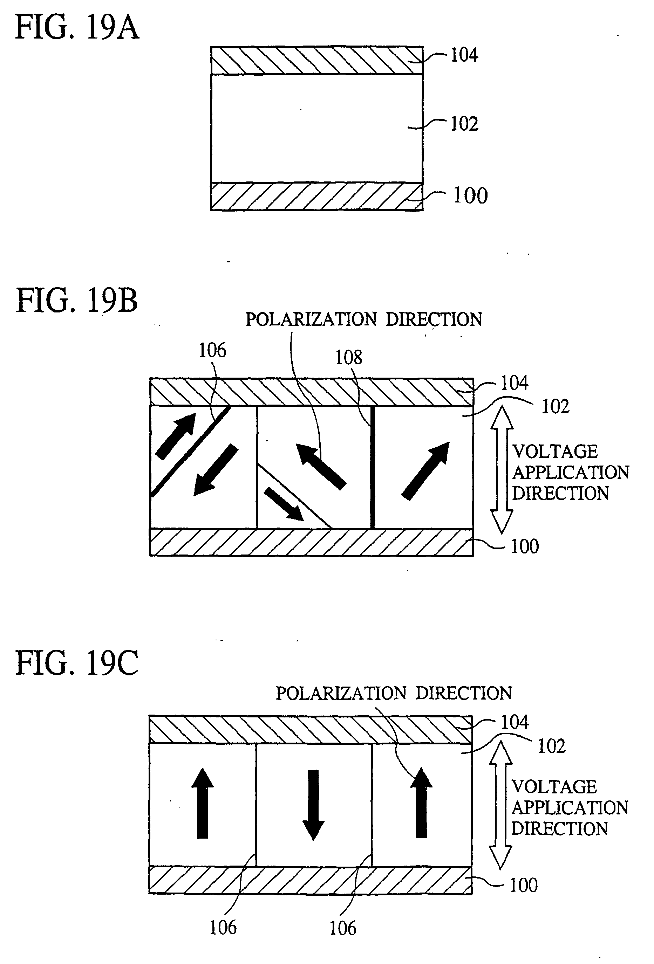

A conventional capacitor using ferroelectric film will first be explained with reference to FIGs. 19A-19C. FIGs. 19A-19C are diagrammatic sectional views of the conventional capacitors.

In FIG. 19A, the conventional capacitor can be seen to comprise a lower electrode 100 of, e.g., platinum, a ferroelectric film 102 of, e.g., Pb(Zr,Ti)O₃ (hereinafter called PZT), and an upper electrode 104 of, e.g., platinum.

If a platinum film is used as the lower electrode 100 and is polycrystal and strongly (111) oriented, (see, e.g., Journal of Applied Physics, 1991, vol. 70, No. 1, pp. 382-388), then a ferroelectric film 102 which is formed of PZT having a Zr/Ti composition ratio of below 0.52/0.48 and a tetragonal system crystal structure is also strongly (111) oriented due to the influence of the platinum film whose lattice structure is similar.

In applying such ferroelectric capacitors to a nonvolatile memory device, information is written by controlling polarization directions of the ferroelectric film. Polarization directions of PZT having a tetragonal system are <001> direction because average positions of positive ions and negative ions are offset from each other in <001> direction. Accordingly, in the ferroelectric capacitor having the (111) oriented PZT film, as shown in FIG. 19B, polarization directions (indicated by the arrows in the drawing) of the PZT film are oblique to the voltage direction. Consequently, with respect to an applied voltage of the capacitor, the polarization which can be obtained is smaller than an intrinsic polarization of PZT.

A region where directions of polarization are aligned is called a domain. FIG.19B shows a 180° domain wall 106, across which domains having polarisation directions differing by 180° are adjacent to each other and a 90° domain wall 108, across which domains having polarization directions differing by 90° are adjacent to each other. When there is polarization inversion at the time of an applied voltage, no stress takes place in the 180° domain wall 106, but stresses take place in the 90° domain wall 108 which result in the degradation of the data retention characteristics of ferroelectric capacitors, especially in nonvolatile memory devices. Accordingly, it is preferable that a ferroelectric film having no 90° domain wall 108 and only the 180° domain wall 106 is used to fabricate a nonvolatile memory device having good characteristics.

Ferroelectric films having 180° domain walls alone are, e.g., (001) oriented tetragonal PZT film and (111) oriented rhombohedral PZT film. As shown in FIG. 19C, the (001) oriented tetragonal PZT film and the (111) oriented rhombohedral PZT film have no 90° domain wall but only 180° domain walls. Furthermore, an applied voltage direction and induced polarization directions (indicated by the arrows in the drawing) of the capacitor are parallel to each other, whereby the intrinsic polarization intensity of the substance can be utilized as it is in the ferroelectric capacitor.

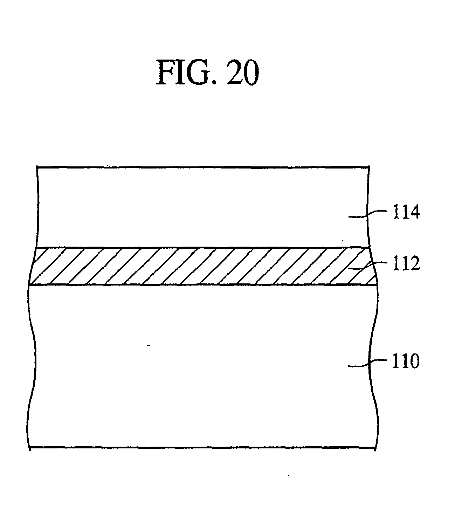

To form (001) oriented PZT film, single crystal MgO substrates of (100) planar orientation and single crystal SrTiO₃ substrates of (100) planar orientation have been used as substrates. As shown in FIG. 20, platinum film is deposited on, e.g., a single crystal (100) MgO substrate 110 by a sputtering method at high temperature, whereby (100) oriented platinum film 112 can be formed on the MgO substrate 110 under the influence of the planar orientation of the MgO substrate 110. PZT film is deposited on the (100) oriented platinum film 112, whereby a (001) oriented PZT film 114 can be formed under the influence of the orientation direction of the platinum film (see, e.g., Journal of Applied Physics, 1991, vol. 69, No. 12, pp. 8352-8357).

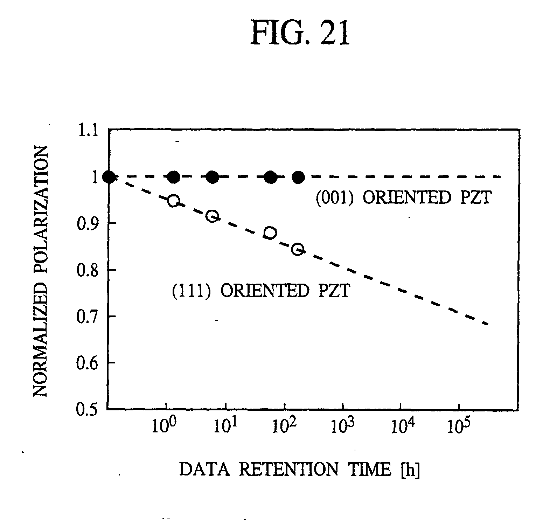

FIG. 21 is a graph of data retention characteristics of a nonvolatile memory device using ferroelectric capacitors containing (111) oriented PZT film, and a nonvolatile memory device using ferroelectric capacitors containing (001) oriented PZT film. The ferroelectric capacitor including the (111) oriented PZT film comprises a lower electrode of (111) oriented platinum film formed on a silicon substrate having a silicon oxide film formed thereon, with the (111) oriented PZT film being formed on the (111) oriented platinum film. The ferroelectric capacitor including the (001) oriented PZT film comprises a lower electrode of the (100) oriented platinum film formed on a (100) oriented MgO substrate, and the (001) oriented PZT film formed on the (100) oriented platinum film. In the graph, retention times after data writing are taken on the horizontal axis, and normalized polarization is taken on the vertical axis.

When the (111) oriented PZT film is used, the polarization decrease as the retention times increase, while in the case that the (001) oriented PZT film is used, decreases of polarization can be suppressed.

In nonvolatile semiconductor memory devices using ferroelectric capacitors, the ferroelectric capacitors are formed over a silicon substrate having active elements formed thereon with an amorphous insulation film being interposed therebetween. A platinum film lower electrode is formed on an adhesion layer of, e.g., TiO₃ film on the amorphous insulation film. The thus-formed platinum film becomes (111) oriented. Thus in a conventional nonvolatile memory device, the PZT film formed on the platinum film also becomes (111) oriented. Ferroelectric capacitors including (001) oriented PZT having good data retention characteristics cannot be formed.

A method of forming (100) oriented platinum film on an amorphous insulation film on a silicon substrate by a sputtering method using Ar gas and O₂ gas is described in, e.g., Journal of Material Research, 1999, vol. 14, No. 3, pp. 634-637. PZT deposited on (100) oriented platinum film becomes (100) oriented , and (001) oriented PZT film, cannot be formed. (100) oriented PZT film has a polarization direction which is perpendicular to an applied electric field, and the resultant polarization is very small.

US 6,096,434 discloses a film structure including a conductive oxide thin film formed on a substrate having a silicon (100) face at it surface. The conductive oxide thin film is an epitaxial film composed mainly of strontium ruthenate, on which a ferroelectric thin film, typically of lead zirconate titanate, having surface flatness and spontaneous polarization is formed.

In US 5,567,979 a buffer layer having crystal orientation in a (111) face is formed on a semiconductor single-crystal (100) substrate and a ferroelectric thin film having crystal orientation in a (111) or (0001) face is then formed over the buffer layer. The thus formed ferroelectric thin film has its axes of polarization aligned in one direction.

US 5,719,417 discloses a method for fabricating a ferroelectric film on a non-conductive substrate in which an adhesion layer is deposited over a substrate, a conductive layer is deposited over the adhesion layer, a seed layer, with a controlled crystal lattice orientation and ferroelectric properties, is deposited on the conductive layer and over the seed layer another ferroelectric material, e.g. lead zirconium titanate, is deposited with a tetragonal or rhombohedral crystalline lattice structure with predetermined and controlled crystal orientation.

In EP 1 160 870 A2 crystallographic texture is introduced into ferroelectric films, whereby the piezoelectric coefficient of the material can be minimized and the electromechanical stresses decoupled.

US 5,248,564 discloses a method for growing a crystalline perovskite film on a silicon dioxide layer by means of an intermediate template layer of a c-axis oriented layered perovskite, such as bismuth titanate.

In conventional capacitors using these ferroelectric materials described above, especially those formed over a silicon substrate interposing an amorphous insulation film therebetween, a PZT film having a polarization axis parallel with an applied electric field direction cannot be formed. In any case, nonvolatile memory devices using such capacitors could not have sufficient data retention characteristics.

An object of the present invention is to provide a ferroelectric capacitor including a ferroelectric film having a polarization axis parallel to an applied electric field direction and a method for fabricating the same, and a semiconductor device comprising such ferroelectric capacitors and having good data retention characteristics and a method for fabricating the same.

According to a first aspect of the present invention there is provided a capacitor comprising: a buffer structure formed on a substrate; a lower electrode formed on the buffer structure; a capacitor dielectric film formed of a perovskite ferroelectric material on the lower electrode; and an upper electrode formed on the capacitor dielectric film; characterized in that: the said buffer structure has a height larger than a width thereof; the perovskite ferroelectric material forming the capacitor dielectric film is selected from the group consisting of <001> oriented tetragonal PZT, <001> oriented tetragonal SrTiO₃, <001> oriented tetragonal Bi₂SrTaO₉, <111> oriented rhombohedral PZT, <111> oriented rhombohedral SrTiO₃, and <111> oriented rhombohedral Bi₂SrTaO₉, and has a smaller thermal expansion coefficient than that of the buffer structure; and the capacitor dielectric film has a crystal oriented substantially perpendicular to a surface of the lower electrode so that a polarization direction of the capacitor dielectric film is made parallel to a direction of an applied electric field between the upper and lower electrodes.

According to a second aspect of the present invention there is provided a capacitor comprising:
a lower electrode formed on a substrate; a capacitor dielectric film of a perovskite ferroelectric material formed on the lower electrode;and an upper electrode formed on the capacitor dielectric film; characterized in that: the said lower electrode has a height larger than a width thereof; the perovskite ferroelectric material forming the capacitor dielectric film is selected from the group consisting of <001> oriented tetragonal PZT, <001> oriented tetragonal SrTiO₃, <001> oriented tetragonal Bi₂SrTaO₉, <111> oriented rhombohedral PZT, <111> oriented rhombohedral SrTiO₃, and <111> oriented rhombohedral Bi₂SrTaO₉ and having a larger thermal expansion coefficient than that of the substrate; and the capacitor dielectric film has a crystal oriented substantially perpendicular to a surface of the lower electrode so that a polarization direction of the capacitor dielectric film is made parallel to a direction of an applied electric field between the upper and lower electrodes.

When a buffer structure underlies the lower electrode, the above result may be achieved when the buffer structure has a larger thermal expansion coefficient than the capacitor dielectric film. Moreover, preferably the thermal expansion coefficient of the capacitor dielectric film is larger than that of the substrate.

When a buffer structure is present the above result may be obtained when the thermal expansion coefficient of the capacitor dielectric film is larger than that of the substrate, moreover, preferably, the thermal expansion coefficient of the lower electrode is larger than that of the capacitor dielectric film.

According to a third aspect of the present invention there is provided a method for fabricating a capacitor comprising the steps of: forming a buffer structure on a substrate; forming a lower electrode on the buffer structure; forming a capacitor dielectric film of a perovskite ferroelectric material on the lower electrode; and forming an upper electrode on the capacitor dielectric film; characterized in that: in the step of forming the buffer structure, the buffer structure having a height larger than a width thereof is formed; and in the step of forming the capacitor dielectric film, the perovskite ferroelectric material forming the capacitor dielectric film is selected from the group consisting of <001> oriented tetragonal PZT, <001> oriented tetragonal SrTiO₃, <001> oriented tetragonal Bi₂SrTaO₉ <111> oriented rhombohedral PZT, <111> oriented rhombohedral SrTiO₃, and <111> oriented rhombohedral Bi₂SrTaO₉, the capacitor dielectric film having a smaller thermal expansion coefficient than that of the buffer structure, and a crystal oriented substantially perpendicular to a surface of the lower electrode so that a polarization direction of the capacitor dielectric film is made parallel to a direction of an applied electric field between the upper and lower electrodes

According to a fourth aspect of the present invention there is provided a method for fabricating a capacitor comprising the steps of: forming a lower electrode on a substrate; forming a capacitor dielectric film of a perovskite ferroelectric material on the lower electrode; and forming an upper electrode on the capacitor dielectric film; characterized in that: in the step of forming the lower electrode, the lower electrode having a height larger than a width thereof is formed; and in the step of forming the capacitor dielectric film, the perovskite ferroelectric material forming the capacitor dielectric film is selected from the group consisting of <001> oriented tetragonal PZT,<001> oriented tetragonal SrTiO₃, <001> oriented tetragonal Bi₂SrTaO₉, <111> oriented rhombohedral PZT, <111> oriented rhombohedral SrTiO₃, and <111> oriented rhombohedral Bi₂SrTaO₉, the capacitor dielectric film having a larger thermal expansion coefficient than that of the substrate, and a crystal oriented substantially perpendicular to a surface of the lower electrode so that a polarization direction of the capacitor dielectric film is made parallel to a direction of an applied electric field between the upper and lower electrodes.

According to the present invention, the buffer layer functions to mitigate the influence of the stress from the substrate and is formed below the lower electrode, which enables, even in a case that the substrate is formed of a material whose thermal expansion coefficient is smaller than that of the capacitor dielectric film, the capacitor dielectric film whose crystal structure is oriented perpendicular to the surface of the lower electrode to be formed. Accordingly, polarization directions of the capacitor dielectric film can be made parallel with a direction of an applied electric field between the upper electrode and the lower electrode, whereby an intrinsic polarization of the ferroelectric film can be utilized.

The lower electrode can alternatively provide a structure which functions also as the buffer layer for mitigating the influence of the stress from the substrate, whereby even in a case that the substrate is formed of a material whose thermal expansion coefficient is smaller than that of the capacitor dielectric film, the capacitor dielectric film whose crystal structure is oriented perpendicular to the surface of the lower electrode can be formed. Accordingly, the polarization direction of the capacitor dielectric film can be parallel to the direction of an electric field applied between the upper electrode and the lower electrode, and an intrinsic polarization of the ferroelectric film can be utilized.

For a better understanding of the invention and to show how the same can be carried into effect, reference will now be made to the accompanying drawings, wherein:
FIGs . 1A and 1B are diagrammatic sectional views of semiconductor structures embodying this invention;
FIG. 2 is a diagrammatic sectional view of a first semiconductor device embodying the present invention.
FIGs. 3A-3D, 4A-4B, and 5A-5B are sectional views showing the semiconductor device of FIG. 2 at various stages in its fabrication.
FIG. 6 is a graph of data retention characteristics of the first semiconductor device the present invention in relation to those of a conventional semiconductor device.
FIGs. 7A and 7B are diagrammatic sectional views of a semiconductor device which is a modification of that of FIG. 2 of the present invention.
FIG. 8 is a diagrammatic sectional view of a second semiconductor device embodying the present invention.
FIGs. 9A-9B are sectional views of the second semiconductor device at stages in its production.
FIGs. 10A and 10B are diagrammatic sectional views of a semiconductor device which is a modification of that of FIG. 8 structure thereof.
FIG. 11 is a diagrammatic sectional view of a third semiconductor device embodying the present invention.
FIGs. 12A-12B, 13A-13B, and 14A-14B are sectional views of the semiconductor device of FIG. 8 at different stages at its production which show the method of fabrication.
FIG. 15 is a diagrammatic sectional view of a fourth semiconductor device embodying the present invention.
FIGs. 16A-16C, 17A-17B, and 18A-18B are sectional views of the fourth semiconductor device embodying the present invention.
FIGs. 19A-19C are diagrammatic sectional views of a conventional semiconductor device.
FIG. 20 is a diagrammatic sectional view showing the conventional method for forming (001) oriented PZT film.
FIG. 21 is a graph of data retention time dependence on normalized polarization of the nonvolatile memory device using (001) oriented PZT film and the nonvolatile memory device using (111) oriented PZT film.
FIG. 22 is a diagrammatic sectional view showing the structure including the buffer layer having larger thermal expansion coefficient than the ferroelectric film formed under the lower electrode.

As described above, even when PZT film is formed on (100) oriented platinum film, the PZT film formed on the platinum film has different orientations depending on whether the base structure is (100) MgO film or an amorphous insulation film formed on a silicon substrate.

The inventors of the present application made earnest studies of causes of the PZT film having different orientation directions depending on base structures of the platinum film and have found for the first time that the difference in thermal expansion coefficient between the ferroelectric film and the base substrate is very influential to orientation of the PZT film. Based on the result of their studies, the inventors consider the relationships between the orientation of PZT film and thermal expansion coefficients to be as follows.

High temperatures are necessary to crystallize the PZT film, so that the PZT film is deposited at a film forming temperature which is above a Curie point (Tc), or the PZT film is subjected, after deposition, to thermal processing at a temperature higher than a Curie point. Thus, in cooling the substrate after the deposition of the PZT film, stress due to the difference in thermal expansion coefficient between the base substrate and the PZT film is experienced. The thermal expansion coefficient of MgO is larger than that of PZT, and the thermal expansion coefficient of silicon is smaller than that of PZT. Accordingly, when PZT film is formed on a platinum film formed on an MgO substrate, compression stress is exerted on the PZT film, and in a case that PZT film is formed on an amorphous insulation film formed on a silicon substrate, reverse, tensile stress, is exerted on the PZT film. The inventors of the present application consider that such different stresses are influential on orientation of the PZT film after cooling. When the tensile stress is exerted to the PZT film, the PZT film undergoes the phase transition from (100) oriented cubic system to (100) oriented tetragonal system. In order to obtain (001) oriented PZT film it will be necessary to use a substrate having a thermal expansion coefficient larger than that of PZT.

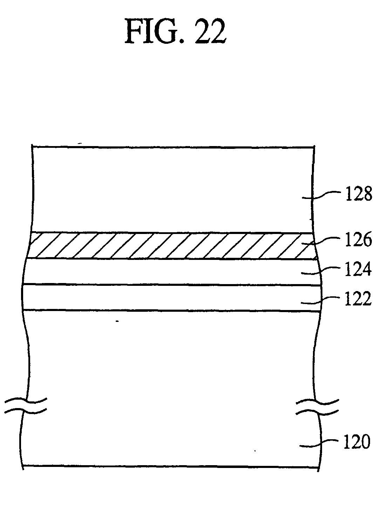

However, when a (100) oriented lower platinum field electrode 126 is formed, as shown in FIG. 22, on a (100) oriented buffer layer 124 formed from a material of large thermal expansion coefficient, such as MgO, on an amorphous insulation film 122 formed on a silicon substrate 120, the PZT film on the platinum film 126 is (100) oriented, and the (001) oriented PZT film cannot be obtained. This is because the influence of the stress due to the thermal expansion coefficient is dominated by a thermal expansion coefficient by the film of greatest thickness within the system. In the system shown in FIG. 22, the stress to be exerted to the PZT is determined by the thermal expansion coefficient of silicon as the substrate and that of PZT.

Based on this, from the viewpoint of preventing the application of the stress to the ferroelectric film due to the thermal expansion coefficient difference between the substrate and the ferroelectric film, the inventors of the present application had the idea of providing a structure below the ferroelectric film as a buffer layer, which is formed of a material of a larger thermal expansion coefficient than the ferroelectric film and is higher than the width along which the structure contacts the base, and has succeeded in forming a capacitor comprising a ferroelectric film whose polarization axis is parallel with an electric field application direction.

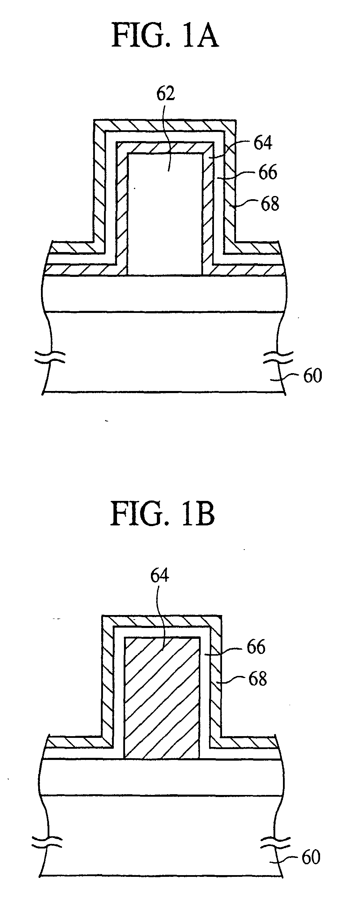

The capacitor according to FIG. 1A is that a capacitor which comprises a buffer layer 62 (also called a buffer structure) formed over a substrate 60, a lower electrode 64 formed on the buffer structure 62, a capacitor dielectric film 66 formed on the lower electrode 64 and formed of a perovskite ferroelectric material having a smaller thermal expansion coefficient than that of the buffer structure 62 and having crystal structures oriented substantially perpendicular to a surface of the lower electrode 64, and an upper electrode 68 formed on a capacitor dielectric film 66.

The capacitor according to FIG. 1B comprises a lower electrode 64 formed over a substrate 60, a capacitor dielectric film 66 formed on the lower electrode 64 and formed of a perovskite ferroelectric material having a larger thermal expansion coefficient than that of the substrate 60 and having crystal structures oriented substantially perpendicular to a surface of the lower electrode 64, and an upper electrode 68 formed on the capacitor dielectric film 68.

The ferroelectric film is formed on either the buffer layer or the lower electrode which functions also as the buffer layer, whereby the stress due to thermal expansion coefficient difference between the ferroelectric film and the substrate can be absorbed.

Consequently, in the cooling processing following the deposition or the thermal crystallization processing of the ferroelectric film, transition of the orientation of the ferroelectric film due to the tensile stress can be prevented. Accordingly, the ferroelectric film has an orientation which is dependent on an orientation of either the buffer structure or the lower electrode, whereby a capacitor comprising a ferroelectric film oriented substantially perpendicular to a surface of the lower electrode, i.e., having a polarization axis parallel with an applied electric field direction can be formed.

It is necessary that the buffer structure has a configuration suitable to prevent exertion of stress to the ferroelectric film due to the thermal expansion coefficient difference between the substrate and the ferroelectric film. It will be preferable that the buffer structure has a pillar-shaped body having a relatively small contact area with respect to the base from the viewpoint of preventing the exertion of stress to the ferroelectric film due to the thermal expansion coefficient difference between the substrate and the ferroelectric film. It will be necessary that the buffer structure is higher than the width along which the buffer structure contacts the base. Although the inventors of the present application have found no critical value of the configuration of the buffer structure, the effect of preventing the application of the stress to the ferroelectric film will be greater as the ratio height of the buffer structure/contact width to the base is larger. It is preferable that a ratio of the height of the buffer structure to a width thereof along which the buffer structure contacts the base is selected corresponding to a thermal expansion coefficient difference between the substrate and the ferroelectric film.

The orientation of the film forming the buffer layer is selected suitably corresponding to the orientation of the ferroelectric film to be formed.

The ferroelectric film having perovskite structure has either a tetragonal system or a rhombohedral system. For example, if the ferroelectric film is PZT-based and has a composition Pb(_{Z}r₁-ₓTiₓ)O₂, the ferroelectric film has a tetragonal system when a composition ratio x is x≥0.48, and when composition ratio x is x≤0.48, the ferroelectric film has rhombohedral system. A tetragonal system ferroelectric film is suitable for the ferroelectric capacitor when the ferroelectric film is (001) oriented, and a rhombohedral system ferroelectric film is suitable for the ferroelectric capacitor when the ferroelectric film is (111) oriented.

In the case that a tetragonal system ferroelectric film is used, the base film is formed of a (100) oriented film, whereby the ferroelectric film tends to have (100) oriented cubic system in the deposition processing at temperatures higher than a Curie temperature or in thermal crystallization processing at temperatures higher than a Curie temperature. The (100) oriented ferroelectric film undergoes phase transition from cubic system to tetragonal system on cooling from a temperature higher than a Curie temperature to the room temperature. At this time, the ferroelectric film is subjected to compression stress by the buffer layer, and the ferroelectric film can have (001) oriented tetragonal system.

If a ferroelectric film of rhombohedral system is used, the base film is formed of a (111) oriented film, with the ferroelectric film tending to have a (111) oriented cubic system in the deposition processing at temperatures higher than the Curie temperature or in thermal crystallization processing at temperatures higher than the Curie temperature. The (111) oriented ferroelectric film undergoes phase transition from a cubic system to a rhombohedral system during cooling from a temperature higher than the Curie temperature to room temperature. A rhombohedral system has, in addition to 180° domain, 70° domain and 110° domain where polarization directions are oblique to the base surface, but in the phase transition, the ferroelectric thin film is subjected to uniform compression stress by the buffer layer to give a rhombohedral system which is (111) oriented, i.e., oriented in the polarization direction.

When the lower electrode is formed of platinum, with the (001) oriented tetragonal ferroelectric film being formed on the lower electrode, it is necessary to form (100) oriented platinum film. This is because to form a (111) oriented rhombohedral ferroelectric film, it is necessary to form (111) oriented platinum film.

The buffer structure can be formed of, e.g., MgO, MgAl₂O₄, CaO, ZrO₂, Y₂O₃, etc. when the buffer layer is formed of an insulating material. These insulating materials have a cubic system, and their orientation can be controlled by controlling the total pressures for forming them. If the buffer layer is formed of a conducting material, it can be formed of, e.g., platinum, silver (Ag), gold (Au), chrome (Cr), copper (Cu), iridium (Ir), nickel (Ni), tantalum (Ta), titanium (Ti), etc. The orientation thereof can be controlled by introducing oxygen (O₂) gas in argon (Ar) gas for their deposition to control partial pressures of the oxygen gas. Out of these materials, noble metals, which are compatible with the ferroelectric film, can be used as common materials of the buffer structure, and the lower electrode, i.e. there is no distinct buffer structure.

The buffer structure is not limited to the solid pillar-shaped body as shown in FIG. 1 and can be a hollow pillar-shaped body which will be described later.

The present invention is applicable widely to ferroelectric materials of perovskite structure. The present invention has been applied to SrTiO₃ film, Bi₂SrTaO₉ film, etc. in addition to PZT film and can produce the same effects.

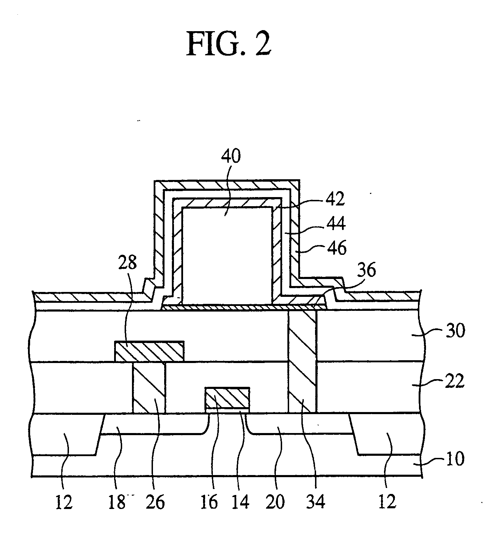

The semiconductor device and the method for fabricating the same according to a first embodiment of the present invention will be explained with reference to FIGs. 2, 3A-3D, 4A-4B, 5A-5B, and 6.

First, the structure of a semiconductor device according to the present embodiment will be explained with reference to FIG. 2.

On a silicon substrate 10 there is formed a memory cell transistor comprising a gate electrode 16 formed on the silicon substrate 10 with a gate insulation film 14 being interposed therebetween, and a source/drain diffused layer 18, 20 formed in the silicon substrate 10 on both sides of the gate electrode 16. An inter-layer insulation film 22 is formed on the silicon substrate 10 with the memory cell transistor formed thereon. A plug 26 buried in the inter-layer insulation film 22 is electrically connected to the source/drain diffused layer 18. A bit line 28 is formed on the inter-layer insulation film 22 and is electrically connected to the source/drain diffused layer 18 through the plug 26. An inter-layer insulation film 30 is formed on the inter-layer insulation film 22 with the bit line 28 formed thereon. A plug 34 is buried in the inter-layer insulation films 30, 22 and is electrically connected to the source/drain diffused layer 20.

A barrier metal layer 36 is formed on the inter-layer insulation film 30 with the plug 34 buried therein. A buffer structure 40 of (100) oriented MgO film is formed on the barrier metal layer 36. A lower electrode 42 of (100) oriented platinum film is formed on the barrier metal layer 36, and the upper surface and the side surface of the buffer structure 40 and is electrically connected to the source/drain diffused layer 20 via the barrier metal layer 36 and the plug 34. On the lower electrode 42, a capacitor dielectric film 44 of (001) oriented tetragonal PZT film is formed.

An upper electrode 46 of a platinum film is formed on the capacitor dielectric film 44. Thus, the lower electrode 42, the capacitor dielectric film 44 and the upper electrode 46 constitute a ferroelectric capacitor.

Thus, a ferroelectric memory device comprising one transistor and one capacitor is fabricated.

The semiconductor device according to the present embodiment is characterized mainly in that silicon is used as the substrate whose thermal expansion coefficient is smaller than that of the capacitor dielectric film 44 and that the capacitor dielectric film 44 is formed of a (001) oriented film. When a tetragonal PZT film is used as the capacitor dielectric film 44, the polarization direction of the (001) oriented PZT film is parallel with the direction of an electric field applied between the upper electrode 46 and the lower electrode 42. Accordingly, the intrinsic polarization of PZT film can be utilized.

In the semiconductor device according to the present embodiment, in order to allow (001) oriented tetragonal PZT film to be formed over the silicon substrate 10, the MgO film buffer structure 40 whose thermal expansion coefficient is larger than that of the capacitor dielectric film is provided below the lower electrode 42. The buffer structure 40 prohibits the application of tensile stress to the PZT film due to a difference of the thermal expansion coefficients between the silicon substrate 10 and the PZT film and conversely permits the application of a compression stress to the PZT film due to the difference of the thermal expansion coefficients between the buffer structure 40 and the PZT film, whereby the (001) oriented tetragonal PZT film can be formed on the lower electrode 42.

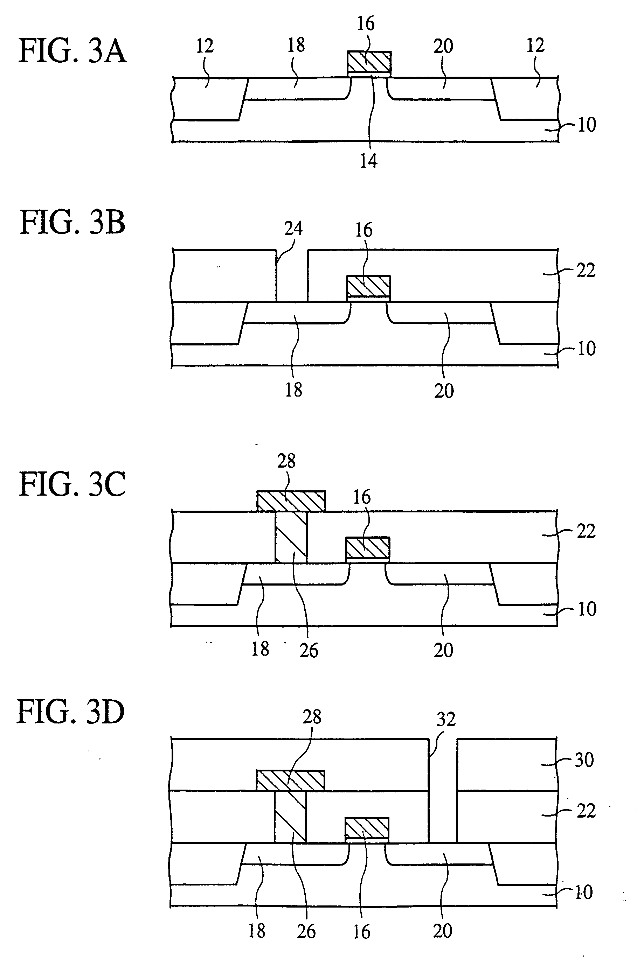

The method for fabricating the semiconductor device according to the present embodiment will be explained with reference to FIGs. 3A-3D, 4A-4B, and 5A-5B.

First, a device isolation film 12 is formed on the silicon substrate 20 by, e.g., shallow trench method.

Then, a memory cell transistor is produced comprising a gate electrode 16 formed on the silicon substrate 10 with the gate insulation film 14 being interposed therebetween. The source/drain diffused layer 18, 20 is formed in the silicon substrate 10 on both sides of the gate electrode 16 in a device region defined by the device isolation film 12 in the same way as in the usual MOS transistor forming method (FIG. 3A).

Next, silicon oxide is deposited on the silicon substrate 10 with the memory cell transistor formed thereon to form the silicon oxide inter-layer insulation film 22.

Then, the surface of the inter-layer insulation film 22 is polished by, e.g., CMP (Chemical Mechanical Polishing) method to planarize the surface of the inter-layer insulation film 22.

A contact hole 24 is formed in the inter-layer insulation film 22 by lithography and etching down to the source/drain diffused layer 18 (FIG. 3B).

Next, the adhesion layer structure of titanium nitride (TiN)/titanium (Ti), and a tungsten (W) film are deposited by, e.g., sputtering method and are polished by CMP method until the surface of the inter-layer insulation film 22 is exposed. The plug 26 is formed, buried in the contact hole 24 and electrically connected to the source/drain diffused layer 18.

Then, a tungsten film is deposited by, e.g., sputtering method and is patterned by lithography and etching to form the tungsten film bit line 28 formed which is and connected to the source/drain diffused layer 18 via the plug 26 (FIG. 3C).

Then, a silicon oxide film is deposited by, e.g., the CVD method on the inter-layer insulation film 22 with the bit line 28 formed thereon to form the silicon oxide inter-layer insulation film 30.

Next, a contact hole 32 is formed by lithography and etching (FIG. 3D) in the inter-layer insulation films 30, 22 down to the source/drain diffused layer 20.

Then, a titanium nitride/titanium adhesion layer, and a tungsten film are deposited by, e.g., sputtering method and are polished by the CMP method until the surface of the inter-layer insulation film 30 is exposed.

The plug 34 is then formed, buried in the contact hole 32 and electrically connected to the source/drain diffused layer 20.

Next, titanium nitride is deposited by, e.g., the sputtering method on the inter-layer insulation film 30 with the plug 34 buried therein to form the titanium nitride barrier metal layer 36.

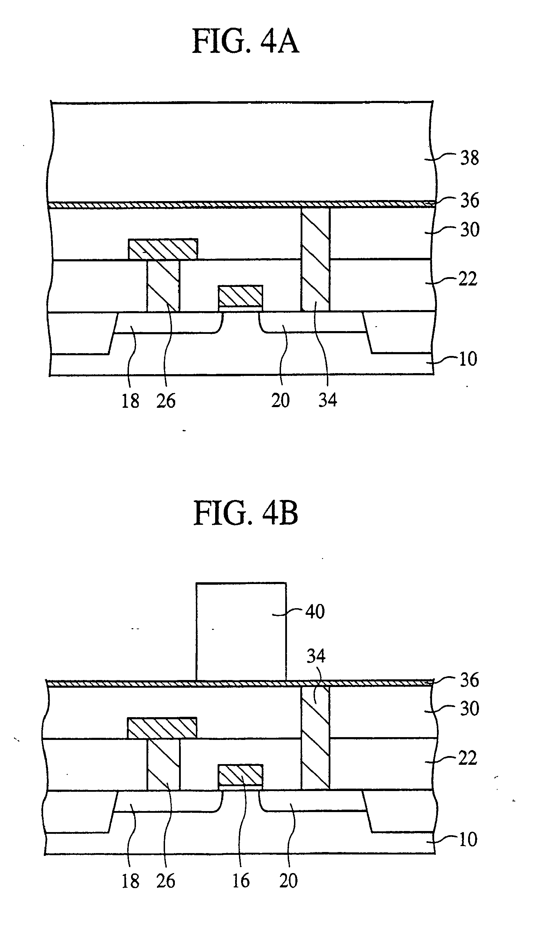

Next, a 600 nm-thick (100) oriented MgO film 38 is deposited on the barrier metal layer 36 by, e.g., the reactive sputtering method (FIG. 4A). The MgO film is formed, for example, with magnesium (Mg) as the target, and O₂ supplied at 500 °C substrate temperature, 30 sccm argon (Ar) gas flow rate and 20 sccm oxygen (O₂) gas flow rate, and 30 mTorr pressure, whereby the (100) oriented MgO film can be formed.

Next, the MgO film 38 is patterned by lithography and ion milling to form the buffer structure 40 of approx 600 nm-height and approx 500 nm-width (100) oriented MgO film 38 (FIG. 4B).

Thus, a buffer structure 40 is formed for prohibiting the application of stress from the silicon substrate 10 to the capacitor dielectric film 44, and which has a height which is at least larger than the width direction dimension along which the buffer structure 40 is in contact with the base. The buffer structure 40 also functions to apply a compression stress to the capacitor dielectric film 44. It is necessary to select, a material forming the buffer structure 40, material having a larger thermal expansion coefficient which is larger than that of a material forming the capacitor dielectric film 44.

A 60 nm-thick (100) oriented platinum film is deposited on the entire surface by, e.g., the CVD method, which is superior for step coverage. The (100) oriented platinum film can be deposited by, e.g., a solution evaporation type CVD method in which oxygen gas is introduced to suitably control oxygen partial pressure.

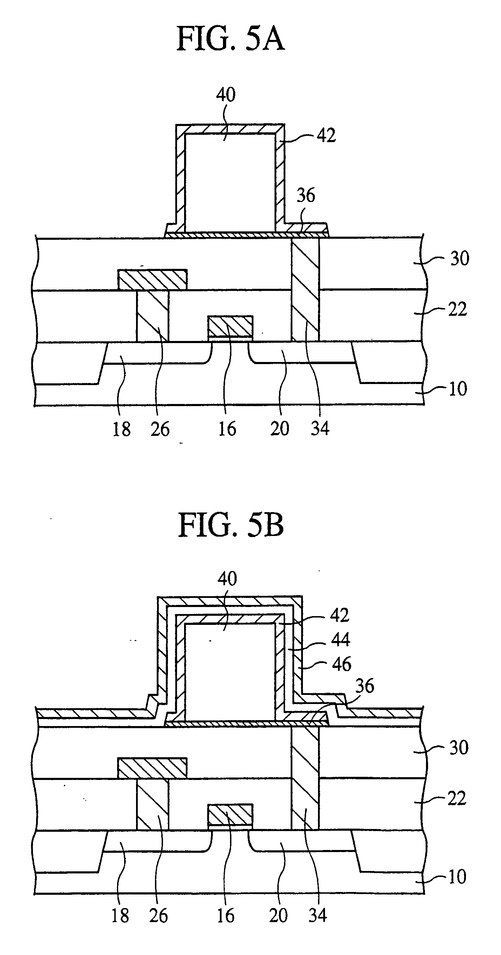

Then, the platinum film and the barrier metal layer 36 are patterned by lithography and etching to produce the lower electrode 42 formed of platinum film and connected to the source/drain diffused layer 20 via the barrier metal layer 36 and the plug 34 (FIG. 5A).

A 120 nm-thick PZT film having a Zr/Ti ratio of 45/55 is deposited on the lower electrode 42 by, e.g., a solution evaporation type CVD method at a temperature above a Curie point (Tc) to form the capacitor dielectric film 44 of the (100) oriented cubic PZT film. The (100) oriented cubic PZT film is subjected to compression stress from the buffer structure 40 while being cooled from the deposition temperature to room temperature and undergoes phase transition to a (001) oriented tetragonal PZT film.

In the cooling process, the tensile stress due to the thermal expansion coefficient difference between the silicon substrate 10 and the PZT film is mitigated by the buffer structure 40 formed below the PZT film, applying compression stress to the PZT film. Consequently, the deposited PZT film does not become a (100) oriented tetragonal film but becomes a (001) oriented tetragonal film.

Then, a 100 nm-thick platinum film is deposited on the entire surface by, e.g., a solution evaporation type CVD method to form the upper electrode 46 of the platinum film.

Thus, a ferroelectric memory device (FIG. 5B) comprising a transistor and a capacitor and having polarization directions of the capacitor dielectric film which are parallel with an electric field application direction can be formed.

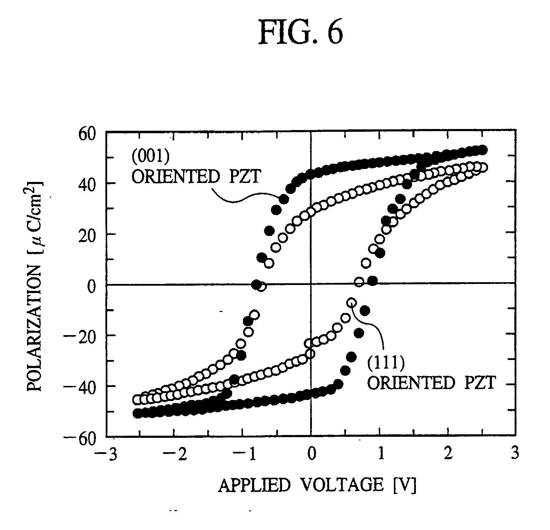

FIG. 6 is a graph of data retention characteristics of the conventional semiconductor device using the (111) oriented PZT film and the semiconductor device according to the present embodiment using the (001) oriented PZT film. The measured results shown in FIG. 6 are data retention characteristics given by accelerated tests made at 150 °C and for 160 hours.

As shown in FIG. 6, an about 25% polarization decrease is found in the conventional semiconductor device using the (111) oriented PZT film, while the polarization decrease could be suppressed to about 5% in the semiconductor device according to the present embodiment.

In the case of using the (001) oriented film, the early polarization is greater by about 1.5 times in comparison with the case of using the (111) oriented film because the polarization directions are parallel with the electric field application direction. This means that in the case of using the (001) oriented film, even when a capacitor area is decreased to 1/1.5 times, characteristics equal to those of the case of using the (111) oriented film can be obtained, which makes it possible to further micronize ferroelectric memories.

As described above, because the buffer structure 40 for mitigating the influence of the stress from the silicon substrate 10 is provided below the lower electrode 42, whereby even when the substrate is formed of silicon whose thermal expansion coefficient is smaller than that of the capacitor dielectric film 44, it is possible for a (001) oriented capacitor dielectric film to be formed. Accordingly, the polarization directions of the capacitor dielectric film can be made parallel with the direction of an applied electric field between the upper electrode 46 and the lower electrode 42, whereby an intrinsic polarization of the ferroelectric film can be utilized.

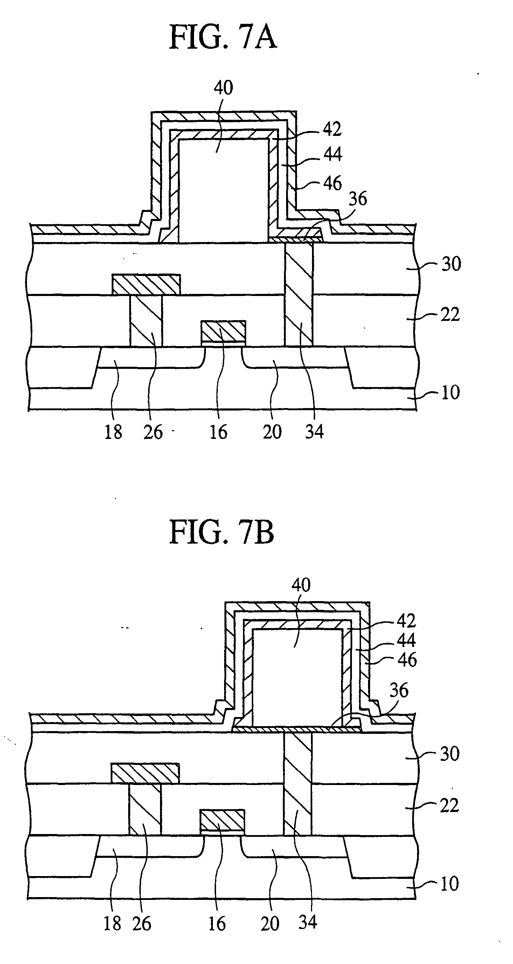

In the present embodiment, the barrier metal layer is, for example, provided between the lower electrode 42 and the plug 34 for improving adhesion between the lower electrode 42 and the base structure, and improving contact characteristics. The layout of the barrier metal layer 36 is not limited to that described in the present embodiment and can be varied. For example, FIG. 7A shows that the barrier metal layer 36 may be disposed selectively on the plug 34 without being extended below the buffer structure 40 and FIG. 7B shows that the barrier metal layer 36 may make contact with the plug 34 below the buffer structure 40.

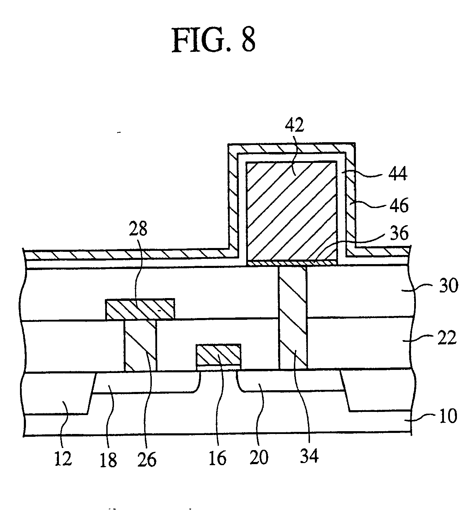

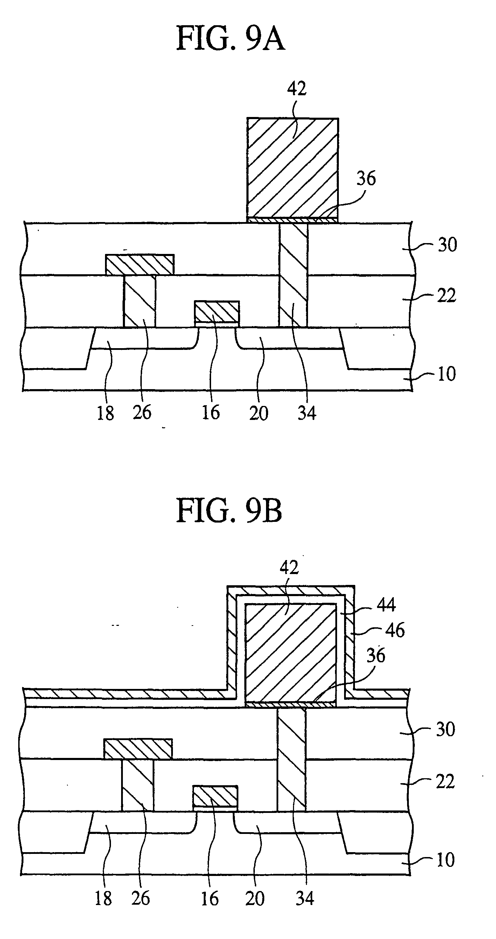

The semiconductor device and the method for fabricating the same according to a second embodiment of the present invention will be explained with reference to FIGs. 8 and 9A-9B. The same reference numerals are used to denote parts which are the same in the first embodiment.

First, the structure of the semiconductor device according to the present embodiment will be explained with reference to FIG. 8.

Beneath the barrier metal 36, the structure is the same as in FIG. 2.

A barrier metal layer 36 is formed on the inter-layer insulation film with the plug 34 buried therein. A lower electrode 42 is formed on the barrier metal layer 36, being formed of a (100) oriented platinum film and electrically connected to the source/drain diffused layer 20 via the barrier metal 36 and the plug 34. The lower electrode 42 also functions as a buffer structure. The height of the lower electrode 42 is larger than the width thereof. A capacitor dielectric film 44 of a (001) oriented tetragonal PZT film is formed on the lower electrode 42. A platinum film upper electrode 46 is formed on the capacitor dielectric film 44. Thus, the lower electrode 42, the capacitor dielectric film 44 and the upper electrode 46 constitute a ferroelectric capacitor.

Thus, a ferroelectric memory device comprising one transistor and one capacitor is formed.

The semiconductor device according to the present embodiment is characterized mainly in that used as the substrate is silicon whose thermal expansion coefficient is smaller than that of the capacitor dielectric film 44 and that the capacitor dielectric film 44 is formed of a (001) oriented film. When a tetragonal PZT film is used as the capacitor dielectric film 44, the polarization direction of the (001) oriented film is parallel with the direction of an electric field applied between the upper electrode 46 and the lower electrode 42. Accordingly, the intrinsic polarization quantity of the PZT film can be utilized.

In the semiconductor device according to the present embodiment, in order to form the (001) oriented tetragonal PZT film over the silicon substrate 10, a buffer function is provided by the lower electrode 42 of the (100) oriented platinum film. The lower electrode 42 prohibits the application to the PZT film of tensile stress due to a difference of the thermal expansion coefficients between the silicon substrate 10 and the PZT film and reversely permits the application to the PZT film of a compression stress due to the difference of the thermal expansion coefficients between the lower electrode 42 and the PZT film, whereby the (001) oriented tetragonal PZT film can be formed on the lower electrode 42.

The method for fabricating the semiconductor device according to the present embodiment will be explained with reference to FIGs. 9A-9B.

First, in the same way as already described in connection with the fabrication of the semiconductor device according to the first embodiment memory cell transistor, inter-layer insulation films 22, 30, contact hole 32, etc. as shown in FIGS. 3A to 3D are formed.

Next, an adhesion layer structure of titanium nitride/titanium, and a tungsten film are deposited by, e.g., a sputtering method and then polished by a CMP method until the surface of the inter-layer insulation film 30 is exposed. Thus, the plug 34 is formed, buried in the contact hole 32 and electrically connected to the source/drain diffused layer 20.

Next, by, e.g. a sputtering method a titanium nitride film is deposited on the inter-layer insulation film 30 with the plug 34 buried therein to form the barrier metal layer 36 of the titanium nitride film.

A 600 nm-thick (100) oriented platinum film is deposited on the barrier metal layer 36 by, e.g., a CVD method. The (100) oriented platinum film can be deposited by, e.g., a solution evaporation type CVD method in which an oxygen partial pressure is controlled.

The platinum film and the barrier metal layer 36 are patterned by lithography and etching to form the lower electrode 42 of the platinum film and connected to the source/drain diffused layer 20 via the barrier metal layer 36 and the plug 34 (FIG. 9A). The lower electrode 42 functions also as a buffer structure and has, e.g., an approx height of 600 nm and an approx 500 nm-width.

The lower electrode 42 of the present embodiment has, in addition to the ordinary function of a lower electrode, the function of preventing the silicon substrate 10 stress to the capacitor dielectric film 44. The lower electrode 42 has a height greater in magnitude than the width thereof along which the lower electrode 42 contacts the base. The lower electrode 42 also has the function of applying compression stress to the capacitor dielectric film 44. For this purpose, it is necessary that a material of the lower electrode 42 has a larger thermal expansion coefficient than the material forming the capacitor dielectric film 44.

Reverting to the manufacturing procedure, to achieve the aforesaid objective, the 120 nm-thick PZT film is deposited on the lower electrode 42 at a temperature which is above its Curie point (Tc) by, e.g., the CVD method to form the capacitor dielectric film 44 of a (001) oriented tetragonal PZT film.

Then, a 100 nm-thick platinum film is deposited on the entire surface by, e.g., the CVD method to form the upper electrode 46 of the platinum film.

Thus, a ferroelectric memory device comprising one transistor and one capacitor and having polarization directions parallel to an electric field application direction is produced.

According to the present embodiment, the lower electrode 42 provides the structure which functions also as a buffer structure for mitigating the influence of the stress from the silicon substrate 10, whereby even when the substrate is formed of silicon, whose thermal expansion coefficient is smaller than that of the capacitor dielectric film 44, a (001) oriented capacitor dielectric film can be formed. Consequently, the polarization directions of the capacitor dielectric film can be made parallel with a direction of an applied electric field between the upper electrode 46 and the lower electrode 42, which allows an intrinsic polarization of the ferroelectric film to be used.

In the present embodiment, the lower platinum field electrode 42, and the barrier metal layer 36 are patterned in the same configuration in the step shown in FIG. 9A, and then the capacitor dielectric film 44 is formed. However, the barrier metal 36 may be etched horizontally by a prescribed amount after the patterning and before the capacitor dielectric film 44 is formed.

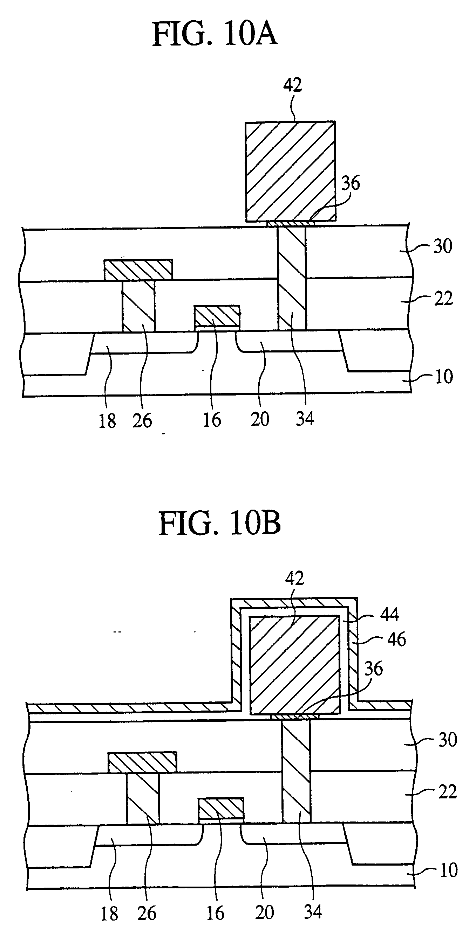

After the step shown in FIG. 9A, the barrier metal layer 36 is isotropically selectively etched by, e.g., an aqueous solution containing sulfuric acid and hydrogen peroxide, to provide a gap between the lower electrode 42 and the inter-layer insulation film 30 as shown in FIG. 10A, whereby the contact area between the lower electrode 42 and the base structure can be substantially decreased. Consequently, the tensile stress applied to the capacitor dielectric film 44 from the silicon substrate 10 in the cooling process following the deposition of the capacitor dielectric film 44 can be further mitigated. In the case that the barrier metal layer 36 is horizontally etched, the device structure after the capacitor dielectric film 44 and the upper electrode 46 have been formed is as exemplified in FIG. 10B.

The degradation of the characteristics of the capacitor dielectric film 44 depends on the composition of the barrier metal layer 36. To prevent the characteristics degradation of the capacitor dielectric film 44, the barrier metal layer 36 is horizontally etched.

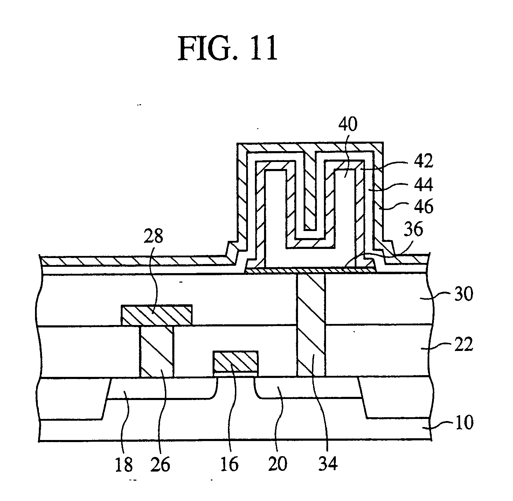

A semiconductor device and a method for fabricating the same according to a third embodiment of the present invention will be explained with reference to FIGs. 11, 12A-12B, 13A-13B, and 14A-14B. The same reference numerals denote like features in the preceding drawings.

First, the structure of the semiconductor device according to the present embodiment will be explained with reference to FIG. 11.

As shown in FIG. 11, the semiconductor device according to the present embodiment is similar to that according to the first embodiment in that a buffer structure 40 is provided below a lower electrode 42.

The semiconductor device according to the present embodiment is characterized mainly in that the buffer structure 40 is not the solid pillar-shaped body as shown in FIG. 2 but is a hollow pillar-shaped body.

The semiconductor device has such constitution as to thereby provide the same effects as those provided by the semiconductor device according to the first embodiment, and a capacitor area which can be easily increased.

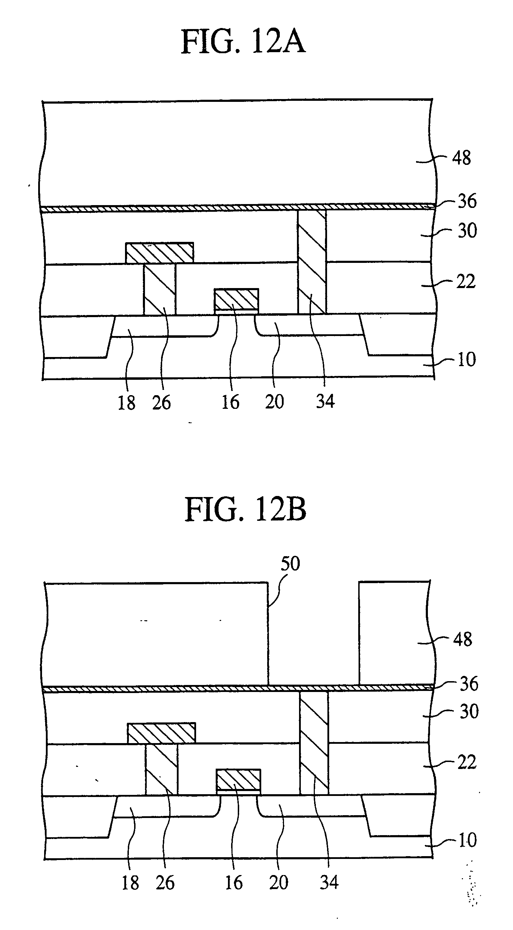

The method for fabricating the semiconductor device according to the present embodiment will be explained with reference to FIGs. 12A-12B, 13A-13B, and 14A-14B.

First, in the same way as in the method for fabricating the semiconductor device according to the first embodiment shown in FIGs. 3A-3D, the memory cell transistor, inter-layer insulation films 22, 30, contact hole 32, etc. are formed.

Then, a titanium nitride/titanium adhesion layer structure, and a tungsten film are deposited by, e.g., sputtering method and then polished by CMP method until the surface of the inter-layer insulation film 30 is exposed. A plug 34 is thus formed, buried in the contact hole 32 and electrically connected to a source/drain diffused layer 20.

Then, a titanium nitride film is deposited by, e.g., a sputtering method, on the inter-layer insulation film 30 with the plug 34 buried therein to form a barrier metal layer 36 of the titanium nitride film.

A 600 nm-thick silicon oxide film is deposited on the barrier metal layer by, e.g., CVD method to form an inter-layer silicon oxide insulation film 48 (FIG. 12A).

The inter-layer insulation film is patterned by lithography and etching to form an opening 50 in the inter-layer insulation film 48 down to the barrier metal layer 36 (FIG. 12B).

Next, a 100 nm-thick (100) oriented MgO film is deposited by, e.g., the reactive sputtering method.

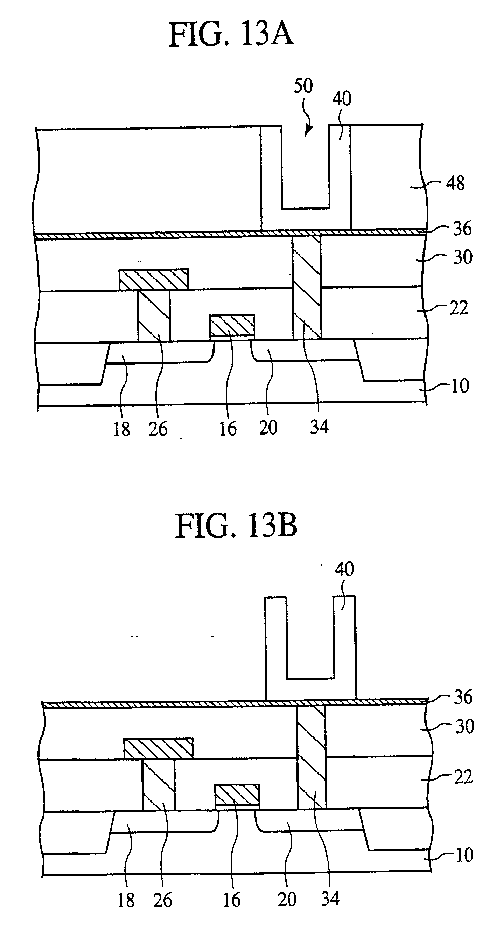

The MgO film is evenly polished by, e.g., the CMP method until the surface of the inter-layer insulation film 48 is exposed to remain selectively in the opening 50. The buffer structure 40 is thus formed from the MgO film along the inside wall and the bottom of the opening 50 (FIG. 13A).

The inter-layer insulation film 48 is then selectively removed by wet-etching with, e.g., a hydrogen fluoride-based aqueous solution, using the barrier metal layer 36 as a stopper (FIG. 13B).

A 60 nm-thick (100) oriented platinum film is now deposited on the entire surface by, e.g., CVD method, which is good for step coverage.

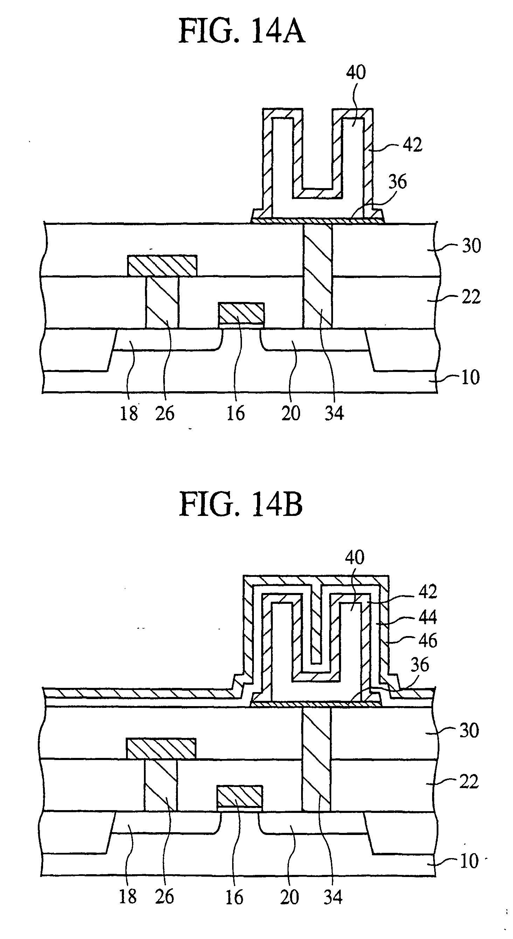

The platinum film and the barrier metal layer 36 are next patterned by lithography and etching to form a lower electrode 42 connected to the source/drain diffused layer 20 via the barrier metal layer 36 and the plug 34 (FIG. 14A).

A 120 nm-thick PZT film is then deposited on the lower electrode 42 by, e.g., a CVD method at a temperature above a Curie point (Tc) to form the capacitor dielectric film 44 of (100) oriented cubic PZT film.

Then, a 100 nm-thick platinum film is deposited on the entire surface by, e.g., CVD method to form an upper electrode 46 of the platinum film (FIG. 14B).

Thus, a ferroelectric memory device comprising one transistor and one capacitor and having polarization directions of the capacitor dielectric film parallel with an applied electric field direction can be fabricated.

As described above, according to the present embodiment, a buffer structure for mitigating the influence of the stress from the silicon substrate 10 is provided below the lower electrode 42, whereby even when the substrate is formed of silicon, whose thermal expansion coefficient is smaller than that of the capacitor dielectric film 44, a (001) oriented capacitor dielectric film can be formed. Consequently, the polarization directions of the capacitor dielectric film can be made parallel with a direction of an applied electric field between the upper electrode 46 and the lower electrode 42, which permits an intrinsic polarization quantity of the ferroelectric film to be utilized.

The buffer structure 40 has a hollow pillar-shaped, whereby the lower electrode 42 can have an increased surface area. Accordingly, the lower electrode having the same floor surface and height can ensure a larger capacitor area, which facilitates higher integration of the element.

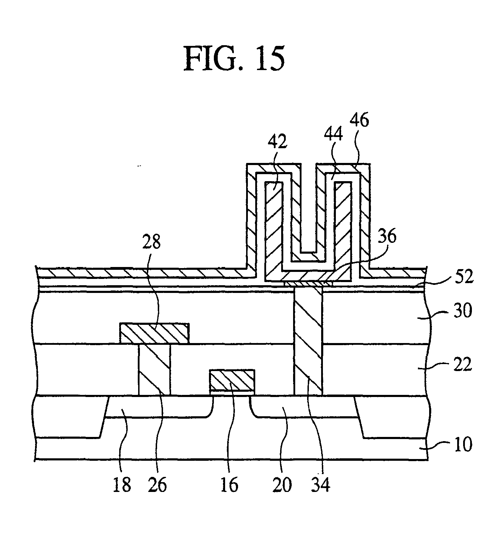

A semiconductor device according to a fourth embodiment of the present invention and a method for fabricating the semiconductor device will now be explained with reference to FIGs. 15, 16A-16C, 17A-17B, and 18A-18B. As previous, like reference numerals denote like features in the preceding figures.

First, the structure of the semiconductor device according to the present embodiment will be explained with reference to FIG. 15.

The semiconductor device according to the present embodiment is the same as the semiconductor device according to the second embodiment in that, as shown in FIG. 15, a lower electrode 42 also functions as a buffer layer. The semiconductor device according to the present embodiment is characterized mainly in that the lower electrode 42 is not solid pillar-shaped as shown in FIG. 8 but is hollow-pillar-shaped. A semiconductor device having such constitution can produce the same effects as the semiconductor device according to the second embodiment and can have an easily increased capacitor area.

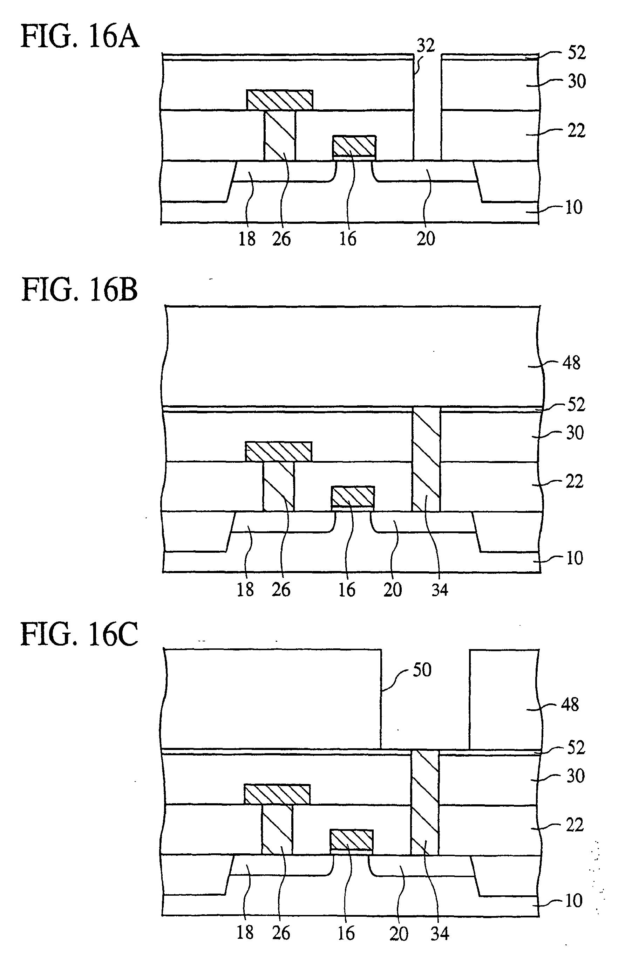

The method for fabricating the semiconductor device according to the present embodiment will now be explained with reference to FIGs. 16A-16C, 17A-17B, and 18A-18B.

First, in the same way as, e.g., in the method for fabricating the semiconductor device according to the first embodiment shown in FIGs. 3A-3C, memory cell transistors, an inter-layer insulation film 22, etc. are formed.

Then, a silicon oxide film is deposited on the inter-layer insulation film 22 by, e.g., CVD method to form an inter-layer silicon oxide insulation film 30.

A silicon nitride film is deposited on the inter-layer insulation film 30 by, e.g., a CVD method to form an etching stopper film 52 of the silicon nitride film.

A contact hole 32 is formed in the etching stopper film 52 and the inter-layer insulation films 30, 22 down to a source/drain diffused layer 20 by lithography and etching (FIG. 16A).

A titanium nitride/titanium adhesion layer structure, and a tungsten film are deposited and the polished by CMP method until the surface of the inter-layer insulation film 30 is exposed. Thus, a plug 34 is formed, buried in the contact hole 32 and electrically connected to the source/drain diffused layer 20.

A 600 nm-thick silicon oxide film is then deposited on the etching stopper film 52 by, e.g., CVD method to form a silicon oxide inter-layer insulation film 48 (FIG. 16B).

The inter-layer insulation film 48 is next patterned by lithography and etching to form in the inter-layer insulation film 48 an opening 50 which reaches the etching stopper film 52 and exposes the plug 34 (FIG. 16C).

A titanium nitride film is then deposited by, e.g., sputtering method to form a titanium nitride film barrier metal layer 36.

A 100 nm-thick (100) oriented platinum film is now deposited on the barrier metal layer 36 by, e.g., the CVD method, which is good for step coverage.

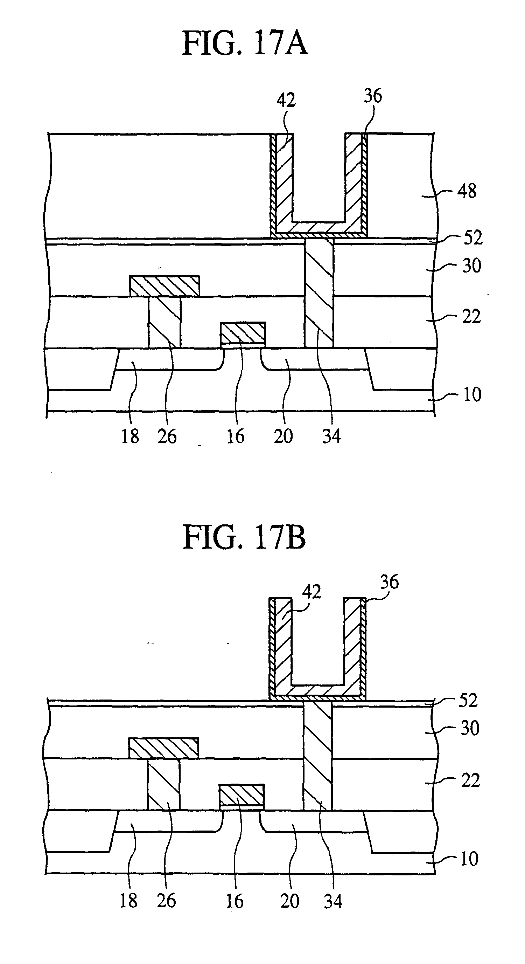

The platinum film and the barrier metal layer 36 are evenly polished by, e.g., CMP method until the surface of the inter-layer insulation film 48 is exposed, to leave the platinum film and the barrier metal layer 36 selectively in the opening 50. Thus, the lower electrode 42 is formed along the inside wall and the bottom of the opening 50, electrically connected to the source/drain diffused layer 20 via the barrier metal layer 36 and the plug 34 (FIG. 17A).

The inter-layer insulation film 48 is then selectively removed by wet-etching with, e.g., a hydrogen fluoride-based aqueous solution, using the etching stopper film 52 as a stopper (FIG. 17B).

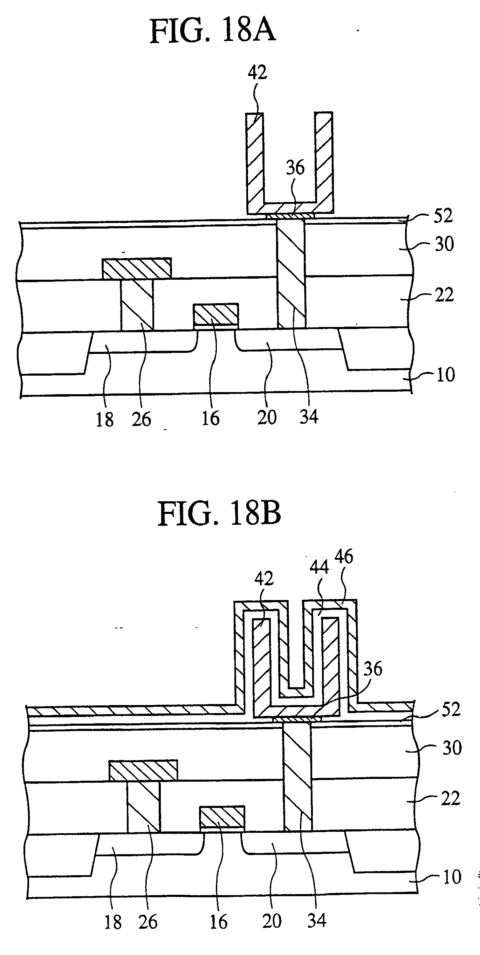

The barrier metal layer 36 is selectively etched with the etching stopper film 52 as a stopper by wet-etching using, e.g., an aqueous solution containing sulfuric acid and hydrogen peroxide (FIG. 18A). In this etching, the barrier metal layer 36 is etched until a gap is formed between the lower electrode 42 and the inter-layer insulation film 30, whereby a contact area between the lower electrode 42 and the base structure can be reduced, whereby the stress applied to the capacitor dielectric film 44 from the silicon substrate 10 in the cooling process following the deposition of the capacitor dielectric film 44 can be further mitigated.

Next, a 120 nm-thick PZT film is deposited on the lower electrode 42 at a temperature above Curie point (Tc) by, e.g., CVD method to form the capacitor dielectric film 44 of the (001) oriented tetragonal PZT film.

Then, a 100 nm-thick platinum film is deposited on the entire surface by, e.g., CVD method to form the upper electrode 46 of the platinum film (FIG. 18B).

Thus, a ferroelectric memory device including one transistor and one capacitor, and a capacitor dielectric film whose polarization directions are parallel with an electric field application direction can be fabricated.

According to the present embodiment, the lower electrode 42 provides the structure which functions also as a buffer structure for mitigating the influence of the stress from the silicon substrate 10, whereby even when the substrate is formed of silicon, whose thermal expansion coefficient is smaller than the capacitor dielectric film 44, the capacitor dielectric film can be (001) oriented. Consequently, polarization directions of the capacitor dielectric film can be parallel with a direction of an electric field applied between the upper electrode 46 and the lower electrode 42, whereby an intrinsic polarization quantity of the ferroelectric film can be utilized.

The lower electrode 42 has a hollow pillar-shaped, whereby the lower electrode 42 can have an increased surface area. Accordingly, the lower electrode having the same floor surface and height can ensure a larger capacitor area, which facilitates higher integration of the element.

The present invention is not limited to the above-described embodiments and can cover other various modifications.

For example, in the above-described embodiments, the lower electrode 42 can be formed of (100) oriented platinum film, and the capacitor dielectric film 44 formed of (001) oriented tetragonal PZT film, but the lower electrode 42 may be formed of (111) oriented platinum film, and the capacitor dielectric film 44 is formed of (111) oriented rhombohedral PZT film.

In the case where a (111) oriented rhombohedral PZT film is used, the polarization directions of the capacitor dielectric film 44 are parallel with the direction of an applied electric field between the upper electrode 46 and the lower electrode 42, whereby an intrinsic polarization of the ferroelectric film can be utilized.
(111) oriented platinum film can be deposited by, e.g., a solution evaporation-type CVD method without oxygen being introduced.
(111) oriented rhombohedral PZT film can be formed by, e.g., a solution evaporation-type CVD method in which raw material flow rates are controlled so that a Zr/Ti ratio is, e.g., 60/40. When the PZT film is deposited at this ratio, the PZT film tends to be a (111) oriented cubic system. (111) oriented PZT film undergoes phase transition from a cubic system to rhombohedral system while being cooled from a temperature above the Curie temperature to room temperature. In the phase transition, the PZT film is subjected to uniform compression stress from the buffer layer to become a (111) oriented rhombohedral PZT film.

A material of the lower electrode 42 and a material of capacitor dielectric film 44 are not limited to a platinum film and a PZT film respectively.

The present invention can be widely used in applications of ferroelectric films of perovskite structure to capacitor dielectric films. The present invention can produce the same effect on SrTiO₃ film, Bi₂SrTaO₉ film, etc. in addition to PZT film.

It is preferable that materials of the lower electrode 42 and the upper electrode 46 are suitably selected for compatibility with the capacitor dielectric film 44. In cases that SrTiO₃ film, Bi₂SrTaO₉ film are used, electrode materials can be platinum, ruthenium, ruthenium oxide, tungsten, SRO (SrRuO₃), and so on.

When the lower electrode 42 is used also as a buffer structure, a variety of conductive materials having larger thermal expansion coefficients than the capacitor dielectric film 44, e.g., platinum, silver (Ag), gold (Au), chrome (Cr), copper (Cu), iridium (Ir), nickel (Ni), tantalum (Ta), titanium (Ti), etc. can be used.

In the first and the third embodiments, the buffer structure 40 is formed of MgO film however, the buffer structure 40 may be formed of a material other than MgO as long as the material has a larger thermal expansion coefficient than the capacitor dielectric film 44 e.g., MgAl₂O₄, CaO, ZrO₂, Y₂O₃, etc. can be used.

The buffer structure 40 is not essentially formed of such insulating materials. The buffer structure 40 may be formed of the above-described platinum, silver, gold, chrome, iridium, nickel, tantalum, etc., and in these cases the lower electrode 42 and the barrier metal layer 36 may not be in contact directly with each other as exemplified in FIGs.2 and 11, due to the intermediate buffer layer 40.

In the above-described embodiments, the ferroelectric capacitor is applied to semiconductor devices, and the ferroelectric capacitor is formed on a silicon substrate. However, the present invention can produce conspicuous effects when the ferroelectric capacitor according to the present invention is formed on substrates having thermal expansion coefficients smaller than that of the ferroelectric film. When the ferroelectric film is formed on substrates having larger thermal expansion coefficients than that of the ferroelectric film, it will not prevent the present invention from producing the effects described above. Accordingly, the substrate is not limited to silicon, and the present invention is applicable to cases where the ferroelectric capacitor is formed on binary compound substrates such as GaAs substrates, oxide substrates, such as MgO substrates, SrTiO₃ substrates, LaAlO₃ substrates, etc.

## Claims

1. A capacitor comprising:
a buffer structure (40) formed on a substrate (10);
a lower electrode (42) formed on the buffer structure (40);
a capacitor dielectric film (44) formed of a perovskite ferroelectric material on the lower electrode (42); and
an upper electrode (46) formed on the capacitor dielectric film (44);
**characterized in that**:
the said buffer structure (40) has a height larger than a width thereof;
the perovskite ferroelectric material forming the capacitor dielectric film (44) is selected from the group consisting of <001> oriented tetragonal PZT, <001> oriented tetragonal SrTiO₃, <001> oriented tetragonal Bi₂SrTaO₉, <111> oriented rhombohedral PZT, <111> oriented rhombohedral SrTiO₃, and <111> oriented rhombohedral Bi₂SrTaO₉, and has a smaller thermal expansion coefficient than that of the buffer structure; and
the capacitor dielectric film (44) has a crystal oriented substantially perpendicular to a surface of the lower electrode (42) so that a polarization direction of the capacitor dielectric film (44) is made parallel to a direction of an applied electric field between the upper and lower electrodes (46, 42).

2. A capacitor according to claim 1, wherein
a thermal expansion coefficient of the capacitor dielectric film (44) is larger than that of the substrate.

3. A capacitor comprising:
a lower electrode (42) formed on a substrate (10);
a capacitor dielectric film (44) of a perovskite ferroelectric material formed on the lower electrode (42) ;and
an upper electrode (46) formed on the capacitor dielectric film (44);
**characterized in that**:
the said lower electrode (42) has a height larger than a width thereof;
the perovskite ferroelectric material forming the capacitor dielectric film (44) is selected from the group consisting of <001> oriented tetragonal PZT, <001> oriented tetragonal SrTiO₃, <001> oriented tetragonal Bi₂SrTaO₉, <111> oriented rhombohedral PZT, <111> oriented rhombohedral SrTiO₃, and <111> oriented rhombohedral Bi₂SrTaO₉ and having a larger thermal expansion coefficient than that of the substrate; and
the capacitor dielectric film (44) has a crystal oriented substantially perpendicular to a surface of the lower electrode (42) so that a polarization direction of the capacitor dielectric film (44) is made parallel to a direction of an applied electric field between the upper and lower electrodes (46, 42).

4. A capacitor according to claim 3, wherein a thermal expansion coefficient of the lower electrode (42) is larger than that of the capacitor dielectric film (44).

5. A capacitor according to claim 1 or 3 wherein, when the capacitor dielectric film (44) is <001> oriented tetragonal PZT, SrTiO₃ or Bi₂SrTaO₉, the lower electrode (42) has <100> oriented cubic crystal structure.

6. A capacitor according to claim 1 or 3, wherein, when
the capacitor dielectric film (44) is <111> oriented rhombohedral PZT, SrTiO₃ or Bi₂SrTaO₉, the lower electrode (42) has <111> oriented cubic crystal structure.

7. A semiconductor device comprising:
a memory cell transistor formed on a semiconductor substrate (10), and including a gate electrode (16), and source/drain diffused layers (18, 20) formed in the semiconductor substrate (10) respectively on both sides of the gate electrode (16);
an insulation film (22, 30) covering the semiconductor substrate (10) on which the memory cell transistor is formed and;
a capacitor as claimed in claim 1 or 2 formed on the insulation film (32, 30), wherein the buffer structure (40) of the capacitor is formed on the insulation film (22, 30), and the lower electrode (42) of the capacitor is electrically connected to one of the source/drain diffused layers (18, 20) .

8. A semiconductor device comprising:
a memory cell transistor formed on a semiconductor substrate (10) and including a gate electrode (16), and source/drain diffused layers (18, 20) formed in the semiconductor substrate (10) respectively on both sides of the gate electrode (16);
an insulation film (22, 30) covering the semiconductor substrate (10) on which the memory cell transistor is formed; and
a capacitor as claimed in claim 3 or 4 formed on the insulation film (22, 30), wherein the lower electrode (42) of the capacitor is formed on the insulation film (22, 30) and is electrically connected to one of the source/drain diffused layers (18,20).

9. A method for fabricating a capacitor comprising the steps of:
forming a buffer structure (40) on a substrate;
forming a lower electrode (42) on the buffer structure (40);
forming a capacitor dielectric film (44) of a perovskite ferroelectric material on the lower electrode (42); and
forming an upper electrode (46) on the capacitor dielectric film (44);
**characterized in that**:
in the step of forming the buffer structure (40), the buffer structure (40) having a height larger than a width thereof is formed; and
in the step of forming the capacitor dielectric film (44), the perovskite ferroelectric material forming the capacitor dielectric film (44) is selected from the group consisting of <001> oriented tetragonal PZT, <001> oriented tetragonal SrTiO₃, <001> oriented tetragonal Bi₂SrTaO₉, <111> oriented rhombohedral PZT, <111> oriented rhombohedral SrTiO₃, and <111> oriented rhombohedral Bi₂SrTaO₉, the capacitor dielectric film (44) having a smaller thermal expansion coefficient than that of the buffer structure (40), and a crystal oriented substantially perpendicular to a surface of the lower electrode(42) so that a polarization direction of the capacitor dielectric film (44) is made parallel to a direction of an applied electric field between the upper and lower electrodes (46, 42).

10. A method for fabricating a capacitor according to claim 9, wherein
in the step of forming the buffer structure (40), a configuration of the buffer structure (40) is set so that a tensile stress due to a thermal expansion coefficient difference between the substrate (10) and the capacitor dielectric film (44) is not applied to the capacitor dielectric film (44) in the step of forming the capacitor dielectric film (44).

11. A method for fabricating a capacitor comprising the steps of:
forming a lower electrode (42) on a substrate (10);
forming a capacitor dielectric film (44) of a perovskite ferroelectric material on the lower electrode (42); and
forming an upper electrode (46) on the capacitor dielectric film (44);
**characterized in that**:
in the step of forming the lower electrode (42), the lower electrode (42) having a height larger than a width thereof is formed; and
in the step of forming the capacitor dielectric film (44), the perovskite ferroelectric material forming the capacitor dielectric film (44) is selected from the group consisting of <00.1> oriented tetragonal PZT, <001> oriented tetragonal SrTiO₃, <001> oriented tetragonal Bi₂SrTaO₉, <111> oriented rhombohedral PZT, <111> oriented rhombohedral SrTiO₃, and <111> oriented rhombohedral Bi₂SrTaO₉, the capacitor dielectric film (44) having a larger thermal expansion coefficient than that of the substrate (10), and a crystal oriented substantially perpendicular to a surface of the lower electrode (42) so that a polarization direction of the capacitor dielectric film (44) is made parallel to a direction of an applied electric field between the upper and lower electrodes (46, 42).

12. A method for fabricating a capacitor according to claim 11, wherein
in the step of forming the lower electrode (42), a configuration of the lower electrode (42) is set so that a tensile stress due to a thermal expansion coefficient difference between the substrate (10) and the capacitor dielectric film (44) is not applied to the capacitor dielectric film (44) in the step of forming the capacitor dielectric film (44).

13. A method for fabricating a capacitor according to claim 9 or 11, wherein, when the capacitor dielectric film (44) is <001> oriented tetragonal PZT, SrTiO₃ or Bi₂SrTaO₉, the lower electrode (42) is formed to have <100> oriented cubic crystal structure.

14. A method for fabricating a capacitor according to claim 9 or 11, wherein when the capacitor dielectric film (44) is <111> oriented rhombohedral PZT, SrTiO₃ or Bi₂SrTaO₉, the lower electrode (42) is formed to have <111> oriented cubic crystal structure.

15. A method for fabricating a semiconductor device comprising the steps of:
forming on a semiconductor substrate (10) a memory cell transistor including a gate electrode (16), and source/drain diffused layers (18, 20) formed in the semiconductor substrate (10) respectively on both sides of the gate electrode (16);
forming an insulation film (22, 30) on the semiconductor substrate (10) on which the memory cell transistor is formed; and
forming on the insulation film (22, 30) a capacitor having a buffer structure (40) formed on the insulation film (22, 30), a lower electrode (42) electrically connected to one of the source/drain diffused layers (18, 20), a capacitor dielectric film (44) formed on the lower electrode (42), and an upper electrode (46) formed on the capacitor dielectric film (44), by a method as claimed in claim 9 or 10.

16. A method for fabricating a semiconductor device comprising the steps of:
forming on a semiconductor substrate (10) a memory cell transistor including a gate electrode (16), and source/drain diffused layers (18, 20) formed in the semiconductor substrate (10) respectively on both sides of the gate electrode (16);
forming an insulation film (22, 30) on the semiconductor substrate (10) on which the memory cell transistor is formed; and
forming on the insulation film (22, 30) a capacitor having a lower electrode (42) formed on the insulation film (22, 30) and electrically connected to one of the source/drain diffused layers (18, 20), a capacitor dielectric film (44) formed on the lower electrode (42) and an upper electrode (46) formed on the capacitor dielectric film (44), by a method as claimed in claim 11 or 12.

## Patentansprüche

1. Kondensator mit:
einer Pufferstruktur (40), die auf einem Substrat (10) gebildet ist;
einer unteren Elektrode (42), die auf der Pufferstruktur (40) gebildet ist;
einem dielektrischen Kondensatorfilm (44), der aus einem ferroelektrischen Perowskit-Material auf der unteren Elektrode (42) gebildet ist; und
einer oberen Elektrode (46), die auf dem dielektrischen Kondensatorfilm (44) gebildet ist;
**dadurch gekennzeichnet, dass**:
die Pufferstruktur (40) eine Höhe hat, die größer als ihre Breite ist;
das ferroelektrische Perowskit-Material, das den dielektrischen Kondensatorfilm (44) bildet, ausgewählt ist aus der Gruppe bestehend aus <001> orientiertem tetragonalen PZT, <001> orientiertem tetragonalen SrTiO₃, <001> orientiertem tetragonalen Bi₂SrTaO₉, <111> orientiertem rhomboedrischen PZT, <111> orientiertem rhomboedrischen SrTiO₁ und <111> orientiertem rhomboedrischen Bi₂SrTaO₉ und einen kleineren Wärmeausdehnungskoeffizienten als die Pufferstruktur hat; und
der dielektrische Kondensatorfilm (44) einen Kristall hat, der im Wesentlichen senkrecht zu einer Oberfläche der unteren Elektrode (42) orientiert ist, so dass eine Polarisationsrichtung des dielektrischen Kondensatorfilms (44) zu einer Richtung eines angewendeten elektrischen Feldes zwischen den oberen und unteren Elektroden (46, 42) parallel wird.

2. Kondensator nach Anspruch 1, bei dem
ein Wärmeausdehnungskoeffizient des dielektrischen Kondensatorfilms (44) größer als jener des Substrates ist.

3. Kondensator mit:
einer unteren Elektrode (42), die auf einem Substrat (10) gebildet ist;
einem dielektrische Kondensatorfilm (44) aus einem ferroelektrischen Perowskit-Material, der auf der unteren Elektrode (42) gebildet ist; und
einer oberen Elektrode (46), die auf dem dielektrischen Kondensatorfilm (44) gebildet ist;
**dadurch gekennzeichnet, dass**:
die untere Elektrode (42) eine Höhe hat, die größer als ihre Breite ist;
das ferroelektrische Perowskit-Material, das den dielektrischen Kondensatorfilm (44) bildet, ausgewählt ist aus der Gruppe betstehend aus <001> orientiertem tetragonalen PZT, <001> orientiertem tetragonalen SrTiO₃, <001> orientiertem tetragonalen Bi₂SrTaO₉, <111> orientiertem rhomboedrischen PZT, <111> orientiertein rhomboedrischen SrTiO₃ und <111> orientiertem rhomboedrischen Bi₂SrTaO₉ und einen größeren Wärmeausdehnungskoeffizienten als das Substrat hat; und
der dielektrische Kondensatorfilm (44) einen Kristall hat, der im Wesentlichen senkrecht zu einer Oberfläche der unteren Elektrode (42) orientiert ist, so dass eine Polarisationsrichtung des dielektrischen Kondensatorfilms (44) zu einer Richtung eines angewendeten elektrischen Feldes zwishen den oberen und unteren Elektroden (46, 42) parallel wird.

4. Kondensator nach Anspruch 3, bei dem ein Wärmeausdehnungskoeffizient der unteren Elektrode (42) größer als jener des dielektrischen Kondensatorfilms (44) ist.

5. Kondensator nach Anspruch 1 oder 3, bei dem dann, wenn der dielektrische Kondensatorfilm (44) <001> orientiertes tetragonales PZT, SrTiO₃ oder Bi₂SrTaO₉ ist, die untere Elektrode (42) eine <100> orientierte kubische KristallStruktur hat.

6. Kondensators nach Anspruch 1 oder- 3, bei dem dann, wenn der dielektrische Kondensatorfilm (44) <111> orientiertes rhomboedrisches PZT, SrTiO₃ oder Bi₂SrTaO₉ ist, die untere Elektrode (42) eine <111< orientierte kubische Kristallstruktur hat.

7. Halbleitervorrichtung mit:
einem Speicherzellentransistor, der auf einem Halbleitersubstrat (10) gebildet ist und eine Gate-Elektrode (16) und diffundierte Source-/Drain-Schichten (18, 20) enthält, die in dem Halbleitersubstrat (10) jeweilig auf beiden Seiten der Gate-Elektrode (16) gebildet sind;
einem Isolierfilm (22, 30), der das Halbleitersubstrat (10) bedeckt, auf dem der Speicherzellentransistor gebildet ist; und
einem Kondensator nach Anspruch 1 oder 2, der auf dem Isolierfilm (22, 30) gebildet ist, wobei die Pufferstruktur (40) des Kondensators auf dem Isolierfilm (22, 30) gebildet ist und die untere Elektrode (42) des Kondensators mit einer von den diffundierten Soure-/Drain-Schichten (18, 20) elektrisch verbunden ist.

8. Halbleitervorrichtung mit:
einem Speicherzellentransistor, der auf einem halbleitersubstrat (10) gebildet ist und eine Gate-Elektrode (16) und diffundierte Source-/Drain-Schichten (18, 20) enthält, die in dem Halbleitersubstrat (10) jeweilig auf beiden SeiLen der Gate-Elektrode (16) gebildet sind;
einem Isolierfilm (22, 30), der das Halbleitersubstrat (10) bedeckt, auf dem der Speicherzellentransistor gebildet ist; und
einem Kondensator nach Anspruch 3 oder 4, der auf dem Isolierfilm (22, 30) gebildet ist, wobei die untere Elektrode (42) des Kondensators auf dem Isolierfilm (22, 30) gebildet ist und mit einer von den diffundierten Source-/ Drain-Schichten (18, 20) elektrisch verbunden ist.

9. Verfahren zum Herstellen eines Kondensators mit den Schritten:
Bilden einer Pufferstruktur (40) auf einem Substrat;
Bilden einer unteren Elektrode (42) auf der Pufferstruktur (40);
Bilden eines dielektrischen Kondensatorfilms (44) aus einem ferroelektrischen Perowskit-Material auf der unteren Elektrode (42); und
Bilden einer oberen Elektrode (46) auf dem dielektrischen Kondensatorfilm (44);
**dadurch gekennzeichnet, dass**:
beim Schritt zum Bilden der Pufferstruktur (40) die Pufferstruktur (40) mit einer Höhe gebildet wird, die größer als ihre Breite ist; und
beim Schritt zum Bilden des dielektrischen Kondensatorfilms (44) das ferroelektrische Perowskit-Material, das den dielektrischen Kondensatorfilm (44) bildet, ausgewählt wird aus der Gruppe bestehend aus <001> orientiertem tetragonalen PZT, <001> orientiertem tetragonalen SrTiO₃, <001> orientiertem tetragonalen Bi₂SrTaO₉, <111> orientiertem rhomboedrischen PZT, <111> orientiertem rhomboedrischen SrTiO₃ und <111> orientiertem rhomboedrischen Bi₂SrTaO₉ wobei der dielektrische Kondensatorfilm (44) einen kleineren Wärmeausdehnungskoeffizienten als die Pufferstruktur (40) hat, und einen Kristall, der im Wesentlichen senkrecht zu einer Oberfläche der unteren Elektrode (42) orientiert ist, so dass eine Polarisationsrichtung des dielektrischen Kondensatorfilms (44) zu einer Richtung eines angewendeten elektrischen Feldes zwischen den oberen und unteren Elektroden (46, 42) parallel wird.

10. Verfahren zum Herstellen eines Kondensators nach Anspruch 9, bei dem
beim Schritt zum Bilden der Pufferstruktur (40) eine Konfiguration der Pufferstruktur (40) so festgelegt wird, dass eine Zugspannung aufgrund einer Differenz der Wärmeausdehnungskoeffizienten zwischen dem Substrat (10) und dem dielektrischen Kondensatorfilm (44) beim Schritt zum Bilden des dielektrischen Kondensatorfilms (44) nicht auf den dielektrischen Kondensatorfilm (44) wirkt.

11. Verfahren zum Herstellen eines Kondensators mit den Schritten:
Bilden einer untere Elektrode (42) auf einem Substrat (10);
Bilden eines dielektrischen Kondensatorfilms (44) aus einem ferroelektrischen Perowskit-Material auf der unteren Elektrode (92); und
Bilden einer oberen Elektrode (46) auf dem dielektrischen Kondensatorfilm (44);
**dadurch gekennzeichnet, dass** :
beim Schritt zum Bilden der unteren Elektrode (42) die untere Elektrode (42) mit einer Höhe gebildet wird, die gröβer als ihre Breite ist; und
beim Schritt zum Bilden des dielektrischen Kondensatorfilms (44) das ferroelektrische Perowskit-Material, das den dielektrischen Kondensatorfilm (44) bildet, ausgewählt wird aus der Gruppe bestehend aus <001> orientiertem tetragonalen PZT, <001> orientiertem tetragonalen SrTiO₃, <001> orientiertem tetragonalen Bi₂SrTaO₉, <111> orientiertem rhomboedrischen PZT, <111> orientiertem rhomboedrischen SrTiO₃ und <111> orientiertem rhomboedrischen Bi₂SrTaO₉, wobei der dielektrische Kondensatorfilm (44) einen größeren Wärmeausdehnungskoeffizienten als das Substrat (10) hat, und einen Kristall, der im Wesentlichen senkrecht zu einer Oberfläche der unteren Elektrode (42) orientiert ist, so dass eine Polarisationsrichtung des dielektrischen Kondensatorfilms (44) zu einer Richtung eines angewendeten elektrischen Feldes zwischen den oberen und unteren Elektroden (46, 42) parallel wird.

12. Verfahren zum Herstellen eines Kondensators nach Anspruch 11, bei dem
beim Schritt zum Bilden der unteren Elektrode (42) eine Konfiguration der unteren Elektrode (42) so festgelegt wird, dass eine Zugspannung aufgrund einer Differenz der Wärmeausdehnungskoeffizienten zwischen dem Substrat (10) und dem dielektrischen Kondensatorfilm (44) beim Schritt zum Bilden des dielektrischen Kondensatorfilms (44) nicht auf den dielektrischen Kondensatorfilm (44) wirkt.

13. Verfahren zum Herstellen eines Kondensators nach Anspruch 9 oder 11, bei dem dann, wenn der dielektrische Kondensatorfilm (44) <001> orientierter tetragonales PZT, SrTiO₃ oder Bi₂SrTaO₉ ist, die untere Elektrode (42) gebildet wird, um eine <100> orientierte kubische Kristallstruktur zu haben.

14. Verfahren zum Herstellen eines Kondensators nach Anspruch 9 oder 11, bei dem dann, wenn der dielektrische Kondensatorfilm (44) <111> orientierte rhomboedrisches PZT, SrTiO₃ oder Bi₂SrTaO₉ ist, die untere Elektrode gebildet wird, um eine <111> orientierte kubische Kristallstruktur zu haben.

15. Verfahren zum Herstellen einer Halbleitervorrichtung mit den Schritten:
Bilden, auf einem Halbleitersubstrat (10), eines Speicherzellentransistors, der eine Gate-Flektrode (16) und diffundierte Source-/Drain-Schichten (18, 20) enthält, die in dem Halbleitersubstrat (10) jeweilig auf beiden Seiten der Gate-Elektrode (16) gebildet sind;
Bilden eines Isolierfilms (22, 30) auf dem HalbleiterSubstrat (10), auf dem der Speicherzellentransistor gebildet ist; und
Bilden, auf dem Isolierfilm (22, 30), eines Kondensators mit einer Pufferstruktur (40), die auf dem Isolierfilm (22, 30) gebildet ist, einer unteren Elektrode (42), die mit einer von den diffundierten Source-/Drain-Schiehten (18, 20) elektrisch verbunden ist, einem dielektrischen Kondensatorfilm (44), der auf der unteren Elektrode (42) gebildet ist, und einer oberen Elektrode (46), die auf dem dielektrischen Kandensatorfilm (44) gebildet ist, durch ein Verfahren nach Anspruch 9 oder 10.

16. Verfahren zum Herstellen einer Halbleitervorrichtung mit den Schritten:
Bilden, auf einem Halbleitersubstrat (10), eines Spcicherzellentransistors, der eine Gate-Elektrode (16) und diffundierte Source-/Drain-Schichten (18, 20) enthält, die in dem Halbleitersubstrat (10) jeweilig auf beiden Seiten der Gate-Elektrode (16) gebildet sind;
Bilden eines Isolierfilms (22, 30) auf dem Halbleitersubstrat (10), auf dem der Speicherzellentransistor gebildet ist; und
Bilden, auf dem Isolicrfilm (22, 30), eines Kondensators mit einer unteren Elektrode (42), die auf dem Isolierfilm (22, 30) gebildet ist und mit einer von den diffundierten Source-/Drain-Schichten (18, 20) elektrisch verbunden ist, einem dielektrischen Kondensatorfilm (44), der auf der unteren Elektrode (42) gebildet ist, und einer oberen Elektrode (46), die auf dem dielektrischen Kondensatorfilm (44) gebildet ist, durch ein Verfahren nach Anspruch 11 oder 12.

## Revendications

1. Condensateur comportant :
une structure tampon (40) formée sur un substrat (10) ;
une électrode inférieure (42) formée sur la structure tampon (40) ;
un film diélectrique de condensateur (44) réalisé en un matériau ferroélectrique de type pérovskite sur l'électrode inférieure (42) ; et
une électrode supérieure (46) réalisée sur le film diélectrique de condensateur (44) ;
**caractérisé en ce que** :
ladite structure tampon (40) présente une hauteur plus large que sa largeur ;
le matériau ferroélectrique de type pérovskite formant le film diélectrique de condensateur (44) est sélectionné parmi le groupe constitué par le PZT tétragonal orienté <001>, le SrTiO₃ tétragonal orienté <001>, le Bi₂SrTaO₉ tétragonal orienté <001>, le PZT rhomboédrique orienté <111>, le SrTiO₃ rhomboédrique orienté <111>, le Bi₂SrTaO₉ rhomboédrique orienté <111>, et possède un coefficient de dilatation thermique inférieur à celui de la structure tampon ; et
le film diélectrique de condensateur (44) possède un cristal orienté sensiblement perpendiculairement à une surface de l'électrode inférieure (42) de sorte qu'une direction de polarisation du film diélectrique de condensateur (44) est rendue parallèle à une direction d'un champ électrique appliqué entre les électrodes supérieure et inférieure (46, 42).

2. Condensateur selon la revendication 1, dans lequel
un coefficient de dilatation thermique du film diélectrique de condensateur (44) est supérieur à celui du substrat.

3. Condensateur comportant :
une électrode inférieure (42) formé sur un substrat (10) ;
un film diélectrique de condensateur (44) réalisé en un matériau ferroélectrique de type pérovskite formé sur l'électrode inférieure (42) _{;} et
une électrode supérieure (46) formée sur le film diélectrique de condensateur (44) ;
**caractérisé en ce que** :
ladite électrode inférieure (42) présente une hauteur plus large que sa largeur ;
le matériau ferroélectrique de type pérovskite formant le film diélectrique de condensateur (44) est sélectionné parmi le groupe constitué par le PZT tétragonal orienté <001>, le SrTiO₃ tétragonal orienté <001>, le Bi₂SrTaO₉ tétragonal orienté <001>, le PZT rhomboédrique orienté <111>, le SrTiO₃ rhomboédrique orienté <111>, le Bi₂SrTaO₉ rhomboédrique orienté <111>, et possède un coefficient de dilatation thermique supérieur à celui du substrat ; et
le film diélectrique de condensateur (44) possède un cristal orienté sensiblement perpendiculairement à une surface de l'électrode inférieure (42) de sorte qu'une direction de polarisation du film diélectrique de condensateur (44) est rendue parallèle à une direction d'un champ électrique appliqué entre les électrodes supérieure et inférieure (46, 42).

4. Condensateur selon la revendication 3, dans lequel un coefficient de dilatation thermique de l'électrode inférieure (42) est supérieur à celui du film diélectrique de condensateur (44).

5. Condensateur selon la revendication 1 ou 3, dans lequel, lorsque le film diélectrique condensateur (44) est du PZT, SrTiO₃ ou Bi₂SrTaO₉ tétragonal orienté <001>, l'électrode inférieure (42) possède une structure cristalline cubique orientée <100>.

6. Condensateur selon la revendication 1 ou 3, dans lequel, lorsque le film diélectrique condensateur (44) est du PZT, SrTiO₃ ou Bi₂SrTaO₉ rhomboédrique orienté <111>, l'électrode inférieure (42) possède une structure cristalline cubique orientée <111>.

7. Dispositif semi-conducteur comportant :
un transistor de cellule de mémoire formé sur un substrat semi-conducteur (10), et comprenant une électrode de grille (16), et des couches diffusées de source/drain (18, 20) formées dans le substrat semi-conducteur (10) respectivement sur les deux côtés de l'électrode de grille (16) ;
un film isolant (22, 30) recouvrant le substrat semi-conducteur (10) sur lequel le transistor de cellule de mémoire est formé ; et
un condensateur selon la revendication et 1 ou 2 formé sur le film isolant (22, 30), dans lequel la structure tampon (40) du condensateur est formée sur le film isolant (22, 30), et l'électrode inférieure (42) du condensateur est électriquement reliée à l'une des couches diffusées de source/drain (18, 20).

8. Dispositif semi-conducteur comportant :
un transistor de cellule de mémoire formé sur un substrat semi-conducteur (10) et comportant une électrode de grille (16), et des couches diffusées de source/drain (18, 20) formées dans le substrat semi-conducteur (10) respectivement sur les deux côtés de l'électrode de grille (16) ;
un film isolant (22, 30) recouvrant le substrat semi-conducteur (10) sur lequel le transistor de cellule de mémoire est formé ; et
un condensateur selon la revendication 3 ou 4 formé sur le film isolant (22, 30), dans lequel l'électrode inférieure (42) du condensateur est formée sur le film isolant (22, 30) et est électriquement reliée à l'une des couches diffusées de source/drain (18, 20).

9. Procédé de fabrication d'un condensateur comportant les étapes consistant à :
former une structure tampon (40) sur un substrat;
former une électrode inférieure (42) sur la structure tampon (40) ;
former un film diélectrique de condensateur (44) réalisé en un matériau ferroélectrique de type pérovskite sur l'électrode inférieure (42) ; et
former une électrode supérieure (46) sur le film diélectrique de condensateur (44) ;
**caractérisé en ce que** :
au cours de l'étape de formation de la structure tampon (40), la structure tampon (40) présentant une hauteur supérieure à sa largeur est formée ; et
au cours de l'étape de formation du film diélectrique de condensateur (44), le matériau ferroélectrique de type pérovskite formant le film diélectrique de condensateur (44) est sélectionné parmi le groupe constitué par le PZT tétragonal orienté <001>, le SrTiO₃ tétragonal orienté <001>, le Bi₂SrTaO₉ tétragonal orienté <001>, le PZT rhomboédrique orienté <111>, le SrTiO₃ rhomboédrique orienté <111>, le Bi₂SrTaO₉ rhomboédrique orienté <111>, le film diélectrique condensateur (44) possédant un coefficient de dilatation thermique inférieur à celui de la structure tampon (40) ; et un cristal orienté sensiblement perpendiculairement à une surface de l'électrode inférieure (42) de sorte qu'une direction de polarisation du film diélectrique de condensateur (44) est rendue parallèle à une direction d'un champ électrique appliqué entre les électrodes supérieure et inférieure (46, 42).

10. Procédé de fabrication d'un condensateur selon la revendication 9, dans lequel
au cours de l'étape d'information de la structure tampon (40), une configuration de la structure tampon (40) est déterminé de sorte qu'une contrainte de traction due à une différence de coefficient de dilatation thermique entre le substrat (10) et le film diélectrique condensateur (44) n'est pas appliquée au film diélectrique de condensateur (44) au cours de l'étape de formation du film diélectrique de condensateur (44).

11. Procédé de fabrication d'un condensateur comportant les étapes consistant à :
former une électrode inférieure (42) sur un substrat (10) ;
former un film diélectrique de condensateur (44) sur un matériau ferroélectrique de type pérovskite sur l'électrode inférieure (42) ; et
former une électrode supérieure (46) sur le film diélectrique de condensateur (44) ;
**caractérisé en ce que** :
au cours de l'étape de formation de l'électrode inférieure (42), l'électrode inférieure (42) présentant une hauteur supérieure à sa largeur est formée ; et
au cours de l'étape de formation du film diélectrique de condensateur (44), le matériau ferroélectrique de type pérovskite formant le film diélectrique de condensateur (44) est sélectionné parmi le groupe constitué par le PZT tétragonal orienté <001>, le SrTiO₃ tétragonal orienté <001>, le Bi₂SrTaO₉ tétragonal orienté <001>, le PZT rhomboédrique orienté <111>, le SrTiO₃ rhomboédrique orienté <111>, le Bi₂SrTaO₉ rhomboédrique orienté <111>, et le film diélectrique de condensateur (44) possédant un coefficient de dilatation thermique supérieur à celui du substrat (10), et un cristal orienté sensiblement perpendiculairement à une surface de l'électrode inférieure (42) de sorte qu'une direction de polarisation du film diélectrique de condensateur (44) est rendue parallèle à une direction d'un champ électrique appliqué entre les électrodes supérieure et inférieure (46, 42).

12. Procédé de fabrication d'un condensateur selon la revendication 11, dans lequel
au cours de l'étape de formation de l'électrode inférieure (42), une configuration de l'électrode inférieure (42) est déterminée de sorte qu'une contrainte de traction due à une différence de coefficient de dilatation thermique entre le substrat (10) et le film diélectrique de condensateur (44) n'est pas appliquée au film diélectrique de condensateur (44) au cours de l'étape de formation du film diélectrique de condensateur (44).

13. Procédé de fabrication d'un condensateur selon la revendication 9 ou 11, dans lequel, lorsque le film diélectrique de condensateur (44) est du PZT, SrTiO₃ ou Bi₂SrTaO₉ tétragonal orienté <001>, l'électrode inférieure (42) est formée pour présenter une structure cristalline cubique orientée <100>.

14. Condensateur selon la revendication 9 ou 11, dans lequel, lorsque le film diélectrique condensateur (44) est du PZT, SrTiO₃ ou Bi₂SrTaO₉ rhomboédrique orienté <111>, l'électrode inférieure (42) est formée pour présenter une structure cristalline cubique orientée <111>.

15. Procédé de fabrication d'un dispositif semi-conducteur comportant les étapes consistant à :
former sur un substrat semi-conducteur (10) un transistor de cellule de mémoire comprenant une électrode de grille (16), et des couches diffusées de source/drain (18, 20) formées dans le substrat semi-conducteur (10) respectivement sur les deux côtés de l'électrode de grille (16) ;
former un film isolant (22, 30) sur le substrat semi-conducteur (10) sur lequel le transistor de cellule de mémoire est formé ; et
former sur le film isolant (22, 30) un condensateur possédant une structure tampon (40) formée sur le film isolant (22, 30), une électrode inférieure (42) reliée électriquement à l'une des couches diffusées de source/drain (18, 20), un film diélectrique de condensateur (44) formé sur l'électrode inférieure (42), et une électrode supérieure (46) formée sur le film diélectrique de condensateur (44), par un procédé selon la revendication 9 ou 10.

16. Procédé de fabrication d'un dispositif semi-conducteur comportant les étapes consistant à :
former sur un substrat semi-conducteur (10) un transistor de cellule de mémoire comprenant une électrode de grille (16), et des couches diffusées de source/drain (18, 20) formées dans le substrat semi-conducteur (10) respectivement sur les deux côtés de l'électrode de grille (16) ;
former un film isolant (22, 30) sur le substrat semi-conducteur (10) sur lequel le transistor de cellule de mémoire est formé ; et
former sur le film isolant (22, 30) un condensateur possédant une électrode inférieure (42) formée sur le film isolant (22, 30) et reliée électriquement à l'une des couches diffusées de source/drain (18, 20), un film diélectrique de condensateur (44) formé sur l'électrode inférieure (42) et une électrode supérieure (46) formée sur le film diélectrique de condensateur (44), par un procédé selon la revendication 11 ou 12.
